# EUROPEAN PATENT APPLICATION

(11) **EP 4 340 024 A1**
(43) Date of publication of application: **20.03.2024**
(21) Application number: 22922942.2
(22) Date of filing: 30.01.2022
(51) Int. Cl.: H01L 27/00

(54) **DISPLAY PANEL AND MANUFACTURING METHOD THEREFOR, AND DISPLAY DEVICE**

(71) Applicant: BOE Technology Group Co., Ltd., Chaoyang District, Beijing 100015 (CN); Chengdu BOE Optoelectronics Technology Co., Ltd., Chengdu, Sichuan 611731 (CN)
(72) Inventor: LI, Meng, Beijing 100176 (CN); WANG, Benlian, Beijing 100176 (CN); KO, Youngyik, Beijing 100176 (CN)
(74) Representative: Hoffmann Eitle
(86) International application number: PCT/CN2022/075193
(87) International publication number: WO 2023/142116

(57) **Abstract**

A display panel, comprising a base substrate, a driving circuit layer, a connecting layer, and an anode layer. The driving circuit layer is disposed on one side of the base substrate, and the driving circuit layer comprises a plurality of first-type pixel driving circuits located in a first display region. The connecting layer is disposed on the side of the driving circuit layer away from the base substrate, the connecting layer comprises at least one conductive layer and at least one insulating layer, an insulating layer is disposed on the side of each conductive layer away from the base substrate, the conductive layer comprises a plurality of connecting wires, and the plurality of connecting wires comprise a plurality of first wires. The anode layer is disposed on the side of the connecting layer away from the base substrate, and the anode layer comprises a plurality of first-type anodes located in a second display region. The plurality of first-type anodes comprise a plurality of first anodes, and every two adjacent first anodes are electrically connected to one first-type pixel driving circuit by means of one first wire.

## Description

### TECHNICAL FIELD

The present disclosure relates to the field of display technologies, and in particular, to a display panel and a method of manufacturing the same, and a display apparatus.

### BACKGROUND

A full display cell (FDC) applies an under-screen camera technology in which a camera and another sensor are hidden directly below a screen, so as to achieve full-screen display.

During normal display of the full display cell, light-emitting devices in a light-emitting device layer emit light to display an image; during an operation of the camera or the another sensor of the full display cell, a part of the light-emitting devices facing the sensor no longer emit light, and the camera or the another sensor receives external light through the transparent light-emitting device layer, so as to perform the operation.

### SUMMARY

In an aspect, some embodiments of the present disclosure provide a display panel. The display panel includes a display region, and the display region includes a first display region and a second display region.

The display panel includes the display region, and the display region includes the first display region and the second display region.

The display panel includes a base substrate, a driving circuit layer disposed on a side of the base substrate, a connection layer and an anode layer. The driving circuit layer includes a plurality of first-type pixel driving circuits located in the first display region. The connection layer includes a plurality of connection lines, and the plurality of connection lines include a plurality of first lines. The anode layer includes a plurality of first-type anodes located in the second display region; the plurality of first-type anodes include a plurality of first anodes, and at least two first anodes are electrically connected to a first-type pixel driving circuit via a first line.

In some embodiments, the plurality of connection lines further include a plurality of third lines, and a third line is connected to the at least two first anodes. The first line is connected to the third line and the first-type pixel driving circuit, so that the at least two first anodes are electrically connected to the first-type pixel driving circuit.

In some embodiments, the plurality of first-type anodes further include a plurality of second anodes and a plurality of third anodes. The plurality of connection lines further include a plurality of second lines. A second anode is electrically connected to another first-type pixel driving circuit via a second line, and a third anode is electrically connected to yet another first-type pixel driving circuit via another second line.

In some embodiments, the at least two first anodes constitute a first anode group; in a first anode group, a second anode and a third anode that are adjacent to one another, a length of a first line electrically connected to the first anode group is less than a length of a second line electrically connected to the second anode, and is less than a length of a second line electrically connected to the third anode.

In some embodiments, the connection layer is disposed on a side of the driving circuit layer away from the base substrate. The anode layer is disposed on a side of the connection layer away from the base substrate.

In some embodiments, the connection layer includes at least one conductive layer and at least one insulating layer, and each conductive layer is provided with an insulating layer on a side away from the base substrate. In some embodiments, the connection layer includes a first conductive layer, a first insulating layer, a second conductive layer and a second insulating layer. The first conductive layer is disposed on the side of the driving circuit layer away from the base substrate. The first insulating layer is disposed on a side of the first conductive layer away from the base substrate. The second conductive layer is disposed on a side of the first insulating layer away from the base substrate. The second insulating layer is disposed on a side of the second conductive layer away from the base substrate. The first conductive layer includes first lines and/or second lines, and the second conductive layer includes first lines and/or second lines. The plurality of connection lines further include the plurality of third lines, and the third line and the first line that are connected to each other are located in a same conductive layer. The first insulating layer has first via holes therein, the second insulating layer has second via holes therein, the first conductive layer is electrically connected to the second conductive layer through the first via holes, and the second conductive layer is electrically connected to the anode layer through the second via holes.

In some embodiments, the plurality of first-type anodes are arranged in a plurality of first-type anode rows, and at least one first-type anode row includes at least two first anodes, at least one second anode and at least one third anode that are arranged in a row. At least two first anodes in a first-type anode row are electrically connected to a first line.

In some other embodiments, the plurality of first-type anodes are arranged in a plurality of first-type anode columns, and at least one first-type anode column includes at least two first anodes, at least one second anode and at least one third anode that are arranged in a column. At least two first anodes in a first-type anode column are electrically connected to a first line.

In some embodiments, first-type anodes in each of the at least one first-type anode row are cyclically arranged according to an order of a second anode, a first anode, a third anode and a first anode. The plurality of connection lines are arranged to constitute a plurality of line groups, and a line group includes at least one first line and at least two second lines. The plurality of connection lines each extend in a first direction, and the first direction is a row direction in which anodes are arranged. In the line group, a first line is connected to the at least two first anodes in the first-type anode row, and a second line is connected to a second anode or a third anode in the first-type anode row.

In some other embodiments, in the line group, a first line is connected to the at least two first anodes in the first-type anode row, the at least two second lines in the line group include at least one first sub-line and at least one second sub-line, a first sub-line is connected to the second anode or the third anode in the first-type anode row, and a second sub-line is connected to a second anode or a third anode in another first-type anode row adjacent to the first-type anode row.

In some embodiments, first-type anodes in each of the at least one first-type anode column are cyclically arranged according to an order of a second anode, a first anode, a third anode and a first anode. The plurality of connection lines are arranged to constitute a plurality of line groups, and a line group includes at least one first line and at least two second lines; the plurality of connection lines each extend in a second direction, and the second direction is a column direction in which anodes are arranged. In the line group, a first line is connected to the at least two first anodes in the first-type anode column, and a second line is connected to a second anode or a third anode in the first-type anode column.

In some other embodiments, in the line group, a first line is connected to the at least two first anodes in the first-type anode column, the at least two second lines in the line group include at least one first sub-line and at least one second sub-line, a first sub-line is connected to the second anode or the third anode in the first-type anode column, and a second sub-line is connected to a second anode or a third anode in another first-type anode column.

In some embodiments, orthographic projections of the plurality of first-type pixel driving circuits on the base substrate are located on one or two sides, in an extending direction of the plurality of connection lines, of orthographic projections of the plurality of first-type anodes on the base substrate.

In some embodiments, a second conductive layer further includes a plurality of second connection portions, a second connection portion is electrically connected to a first-type anode, and a connection line located in the second conductive layer is electrically connected to the first-type anode via the second connection portion. A first conductive layer further includes a plurality of first connection portions, a first connection portion is electrically connected to the second connection portion, and a connection line located in the first conductive layer is electrically connected to the first-type anode via the first connection portion and the second connection portion that are connected to each other.

In some embodiments, the plurality of first lines and a plurality of third lines are located in the second conductive layer; in a first line and a third line that are connected to each other, the third line is connected to two adjacent second connection portions, so as to be connected to two adjacent first anodes; the first line is connected to one of the two adjacent second connection portions. An orthographic projection, on the base substrate, of the one of the two adjacent second connection portions that is connected to the first line is closer to an orthographic projection, on the base substrate, of a first-type pixel driving circuit electrically connected to the two adjacent first anodes than an orthographic projection, on the base substrate, of another of the two adjacent second connection portions.

In some other embodiments, the plurality of first lines and a plurality of third lines are located in the first conductive layer. In a first line and a third line that are connected to each other, the third line is connected to two adjacent first connection portions, so as to be connected to two adjacent first anodes; the first line is connected to one of the two adjacent first connection portions. An orthographic projection, on the base substrate, of the one of the two adjacent first connection portions that is connected to the first line is closer to an orthographic projection, on the base substrate, of a first-type pixel driving circuit electrically connected to the two adjacent first anodes than an orthographic projection, on the base substrate, of another of the two adjacent first connection portions.

In some embodiments, the driving circuit layer further includes a plurality of second-type pixel driving circuits arranged in an array in the first display region, and the plurality of first-type pixel driving circuits are respectively disposed in gaps of the array of the plurality of second-type pixel driving circuits. The anode layer further includes a plurality of second-type anodes located in the first display region, and a second-type anode is electrically connected to a second-type pixel driving circuit.

In some embodiments, the first line, the second line and the third line each include a transparent conductive material.

In some embodiments, the insulating layer includes a transparent insulating material.

In another aspect, some embodiments of the present disclosure further provide a display apparatus. The display apparatus includes the display panel as described in any one of the above embodiments, and at least one sensor. The sensor is disposed on a non-display side of the display panel, and an orthographic projection of the sensor on the display panel is located in the second display region.

In yet another aspect, some embodiments of the present disclosure further provide a method of manufacturing a display panel. The display panel includes a display region, and the display region includes a first display region and a second display region. The method of manufacturing the display panel includes: providing a base substrate; forming a driving circuit layer on the base substrate; the driving circuit layer including a plurality of first-type pixel driving circuits, and the plurality of first-type pixel driving circuits being disposed in the first display region; forming a connection layer; the connection layer including a plurality of connection lines, and the plurality of connection lines including first lines; and forming an anode layer. The anode layer includes a plurality of first-type anodes located in the second display region; the plurality of first-type anodes include a plurality of first anodes, a plurality of second anodes and a plurality of third anodes, at least two first anodes are electrically connected to a first-type pixel driving circuit via a first line, a second anode is electrically connected to another first-type pixel driving circuit via a second line, and a third anode is electrically connected to yet another first-type pixel driving circuit via another second line.

In some embodiments, the connection layer includes a first conductive layer, a first insulating layer, a second conductive layer and a second insulating layer that are sequentially arranged on a side of the driving circuit layer away from the base substrate. Forming the connection layer on the side of the driving circuit layer away from the base substrate includes: forming a first conductive material layer on the side of the driving circuit layer away from the base substrate, and patterning the first conductive material layer by using a first mask, so as to form the first conductive layer having patterns; forming a first insulating material layer on a side of the first conductive layer away from the base substrate, and patterning the first insulating material layer by using a second mask, so as to form the first insulating layer having patterns; forming a second conductive material layer on a side of the first insulating layer away from the base substrate, and patterning the second conductive material layer by using a third mask, so as to form the second conductive layer having patterns; and forming a second insulating material layer on a side of the second conductive layer away from the base substrate, and patterning the second insulating material layer by using a fourth mask, so as to form the second insulating layer having patterns. Patterns of the first conductive layer include first lines and/or second lines; patterns of the second conductive layer include first lines and/or second lines; patterns of the first insulating layer include first via holes; patterns of the second insulating layer include second via holes.

### BRIEF DESCRIPTION OF THE DRAWINGS

In order to describe technical solutions in the present disclosure more clearly, accompanying drawings to be used in some embodiments of the present disclosure will be introduced briefly below. Obviously, the accompanying drawings to be described below are merely accompanying drawings of some embodiments of the present disclosure, and a person of ordinary skill in the art can obtain other drawings according to these drawings. In addition, the accompanying drawings in the following description may be regarded as schematic diagrams, and are not limitations on actual sizes of products, actual processes of methods and actual timings of signals involved in the embodiments of the present disclosure.
FIG. 1 is a structural diagram of a display apparatus, in accordance with some embodiments;
FIG. 2 is a structural diagram of a display panel, in accordance with some embodiments;
FIG. 3 is a section view taken along the section line A-A in FIG. 2;
FIG. 4 is a schematic diagram showing a connection manner between pixel driving circuits and respective light-emitting devices, in accordance with some embodiments;
FIG. 5 is a section view of another display panel, in accordance with some embodiments;
FIG. 6 is a schematic diagram showing a connection manner between pixel driving circuits and respective light-emitting devices, in accordance with some embodiments;
FIG. 7A is a section view of a connection layer, in accordance with some embodiments;
FIG. 7B is a section view of another connection layer, in accordance with some embodiments;
FIGS. 8A to 8C are each a schematic diagram showing a connection manner between connection lines and an anode layer, in accordance with some embodiments;
FIGS. 9A to 9C are each a schematic diagram showing another connection manner between connection lines and an anode layer, in accordance with some embodiments;
FIGS. 10A to 10C are each a schematic diagram showing yet another connection manner between connection lines and an anode layer, in accordance with some embodiments;
FIG. 11 is a schematic diagram showing a connection manner between an anode layer and line groups, in accordance with some embodiments;
FIG. 12 is a schematic diagram showing yet another connection manner between pixel driving circuits and respective light-emitting devices, in accordance with some embodiments;
FIG. 13 is a schematic diagram showing another connection manner between an anode layer and line groups, in accordance with some embodiments;
FIG. 14 is a schematic diagram showing yet another connection manner between pixel driving circuits and respective light-emitting devices, in accordance with some embodiments;
FIG. 15 is a schematic diagram showing yet another connection manner between pixel driving circuits and respective light-emitting devices, in accordance with some embodiments;
FIG. 16 is a section view of a display apparatus, in accordance with some embodiments;
FIG. 17 is a flow diagram of a method of manufacturing a display panel, in accordance with some embodiments;
FIGS. 18A to 18F are each a diagram showing steps of manufacturing a display panel, in accordance with some embodiments;
FIG. 19 is a flow diagram of a method of manufacturing a connection layer, in accordance with some embodiments; and
FIGS. 20A to 20P are each a diagram showing steps of manufacturing a connection layer, in accordance with some embodiments.

### DETAILED DESCRIPTION

Technical solutions in some embodiments of the present disclosure will be described clearly and completely below with reference to the accompanying drawings. Obviously, the described embodiments are merely some but not all embodiments of the present disclosure. All other embodiments obtained by a person of ordinary skill in the art based on the embodiments of the present disclosure shall be included in the protection scope of the present disclosure.

Unless the context requires otherwise, throughout the specification and the claims, the term "comprise" and other forms thereof such as the third-person singular form "comprises" and the present participle form "comprising" are construed as an open and inclusive meaning, i.e., "including, but not limited to". In the description of the specification, the terms such as "one embodiment", "some embodiments", "exemplary embodiments", "example", "specific example" or "some examples" are intended to indicate that specific features, structures, materials or characteristics related to the embodiment(s) or example(s) are included in at least one embodiment or example of the present disclosure. Schematic representations of the above terms do not necessarily refer to the same embodiment(s) or example(s). In addition, the specific features, structures, materials or characteristics may be included in any one or more embodiments or examples in any suitable manner.

Hereinafter, the terms such as "first" and "second" are used for descriptive purposes only, and are not to be construed as indicating or implying the relative importance or implicitly indicating the number of indicated technical features. Thus, a feature defined with "first" or "second" may explicitly or implicitly include one or more of the features. In the description of the embodiments of the present disclosure, the term "a plurality of" or "the plurality of" means two or more unless otherwise specified.

In the description of some embodiments, the terms such as "coupled" and "connected" and derivatives thereof may be used. For example, the term "connected" may be used in the description of some embodiments to indicate that two or more components are in direct physical or electrical contact with each other. For another example, the term "coupled" may be used in the description of some embodiments to indicate that two or more components are in direct physical or electrical contact. However, the term "coupled" or "communicatively coupled" may also mean that two or more components are not in direct contact with each other, but still cooperate or interact with each other. The embodiments disclosed herein are not necessarily limited to the content herein.

Additionally, the phase "based on" as used herein is meant to be open and inclusive, since a process, a step, a calculation or other action that is "based on" one or more of stated conditions or values may, in practice, be based on additional conditions or values beyond those stated.

As used herein, the term such as "parallel", "perpendicular" or "equal" includes a stated condition and a condition similar to the stated condition, a range of the similar condition is within an acceptable range of deviation, and the acceptable range of deviation is determined by a person of ordinary skill in the art, considering measurement in question and errors associated with measurement of a particular quantity (i.e., limitations of a measurement system). For example, the term "parallel" includes absolute parallelism and approximate parallelism, and an acceptable range of deviation of the approximate parallelism may be, for example, a deviation within 5°; the term "perpendicular" includes absolute perpendicularity and approximate perpendicularity, and an acceptable range of deviation of the approximate perpendicularity may also be, for example, a deviation within 5°. The term "equal" includes absolute equality and approximate equality, and an acceptable range of deviation of the approximate equality may be that, for example, a difference between the two that are equal is less than or equal to 5% of either of the two.

It will be understood that, in a case where a layer or an element is referred to as being on another layer or a substrate, it may be that the layer or the element is directly on the another layer or the substrate, or there may be a middle layer between the layer or the element and the another layer or the substrate.

Exemplary embodiments are described herein with reference to sectional views and/or plan views as idealized exemplary drawings. In the accompanying drawings, thicknesses of layers and sizes of regions are enlarged for clarity. Thus, variations in shape relative to the accompanying drawings due to, for example, manufacturing technologies and/or tolerances may be envisaged. Therefore, the exemplary embodiments should not be construed as being limited to the shapes of the regions shown herein, but including shape deviations due to, for example, manufacturing. For example, an etched region shown in a rectangular shape generally has a feature of being curved. Therefore, the regions shown in the accompanying drawings are schematic in nature, and their shapes are not intended to show actual shapes of regions in a device, and are not intended to limit the scope of the exemplary embodiments.

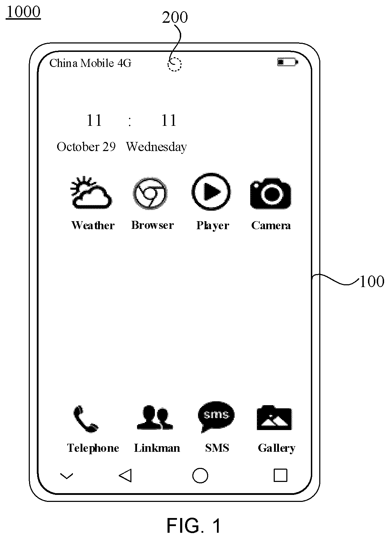

As shown in FIG. 1, a display apparatus 1000 may include, in addition to a display panel 100, an electrical element such as a sensor 200 (e.g., an optical sensor). In an example where the display apparatus 1000 is a mobile phone, the display apparatus 1000 includes a front-facing camera, an optical proximity sensor, a three-dimensional (3D) sensing module or other optical sensors; these optical components each need to receive light from a display side of the display apparatus 1000 to achieve a respective function. In the display apparatus 1000, the optical sensor is generally disposed on a non-display side of the display panel 100, and a photosensitive side of the optical sensor faces the display panel 100.

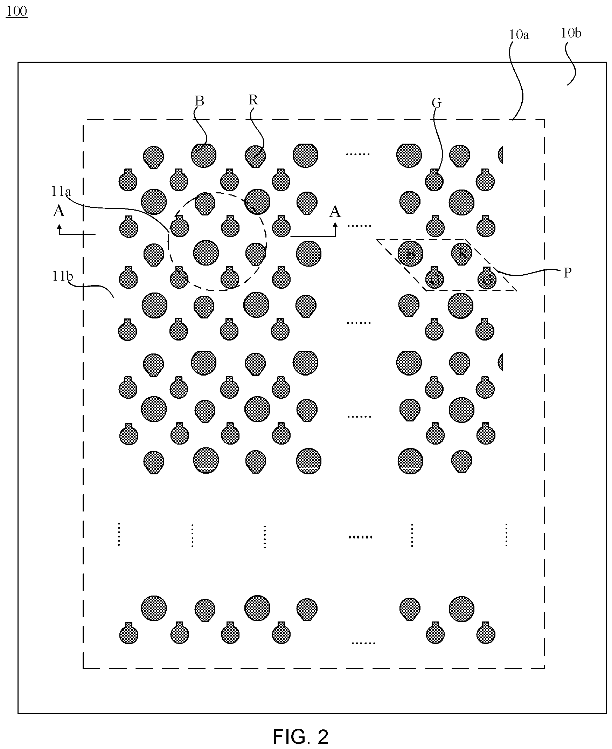

Some embodiments of the present disclosure provide a display panel. The display panel may be, for example, an organic light-emitting diode (OLED) display panel, a micro organic light-emitting diode (Micro OLED) display panel, a quantum dot light emitting diodes (QLED) display panel, a mini light-emitting diode (Mini LED) display panel or a micro light-emitting diode (Micro LED) display panel. The following is described by taking an example where the display panel is the OLED display panel. As shown in FIG. 2, the display panel 100 includes a display region 10a and a peripheral region 10b located on a side of the display region 10a or surrounding the display region 10a. The display region 10a is provided with a plurality of pixels P therein, and each pixel P includes a red sub-pixel R, a blue sub-pixel B and green sub-pixels G. Each sub-pixel includes a light-emitting device and a pixel driving circuit that controls the light-emitting device to emit light. Luminance (gray scales) of sub-pixels of different colors is adjusted by respective pixel driving circuits, so that display of a plurality of colors may be achieved by a combination and a superposition of the colors. As a result, full-color display of the display panel 100 is achieved.

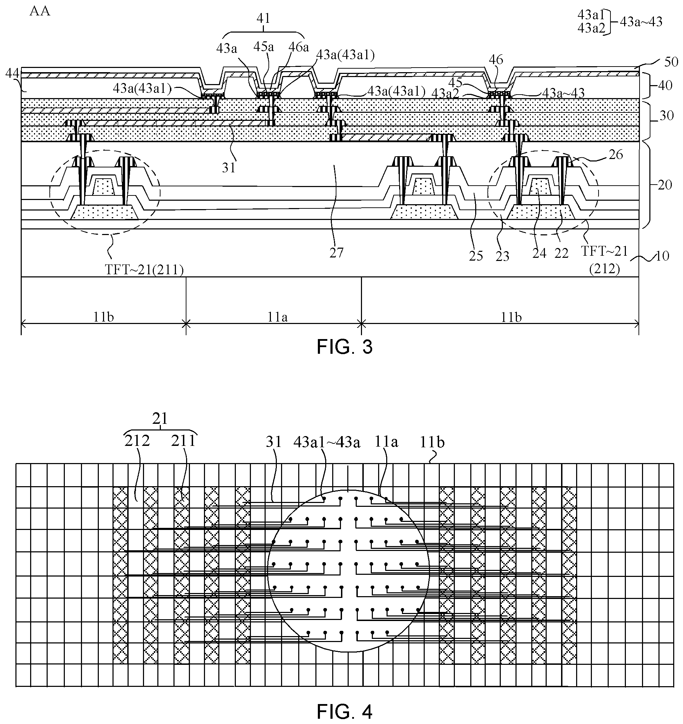

As shown in FIG. 3, the display panel 100 includes a base substrate 10, a driving circuit layer 20, a connection layer 30, a light-emitting device layer 40 and an encapsulation layer 50. The driving circuit layer 20 is disposed on the base substrate 10, and the driving circuit layer 20 includes a plurality of pixel driving circuits 21; the light-emitting device layer 40 includes a plurality of light-emitting devices 41 such as OLEDs, each light-emitting device 41 includes an anode 411, a light-emitting layer 412 and a cathode 413; each pixel driving circuit 21 is electrically connected to a respective light-emitting device 41. Specifically, the pixel driving circuit 21 is electrically connected to an anode 411 of the respective light-emitting device 41, so as to control the respective light-emitting device 41 to emit light. The encapsulation layer 50 is covered on a side of the light-emitting device layer 40 away from the base substrate 10, so as to achieve an encapsulation for the display panel 100.

In some embodiments, the driving circuit layer 20 is disposed on a side of the base substrate 10; the driving circuit layer 20 includes a semiconductor layer 22, a gate insulating layer 23, a gate layer 24, an interlayer insulating layer 25, a source-drain metal layer 26 and a planarization layer 27 that are sequentially arranged on the base substrate 10. The plurality of pixel driving circuits 21 in the driving circuit layer 20 are arranged in an array, and each pixel driving circuit 21 includes a plurality of thin film transistors TFT. The connection layer 30 is disposed on a side of the driving circuit layer 20 away from the base substrate 10; the connection layer 30 includes at least one conductive layer and at least one insulating layer, and each conductive layer is provided with an insulating layer on a side away from the base substrate 10; the connection layer 30 includes a plurality of connection lines 31, and the driving circuit layer 20 is electrically connected to the light-emitting device layer 40 via the connection layer 30.

The light-emitting device layer 40 is disposed on a side of the connection layer 30 away from the base substrate 10, and the light-emitting device layer 40 includes a pixel definition layer 44, an anode layer 43, a light-emitting film layer 45 and a cathode layer 46. The anode layer 43 includes a plurality of anodes 43a. The light-emitting film layer 45 includes a plurality of light-emitting layers 45a. The pixel definition layer 44 includes a plurality of openings. Each opening exposes an anode 43a. Each light-emitting layer 45a is located within an opening and in contact with a respective anode 43a, and a portion of the cathode layer 46 located within the opening serves as a respective cathode 46a, so that the anode 43a, the light-emitting layer 45a and the cathode 46a that are sequentially stacked constitute a light-emitting device 41. The plurality of light-emitting devices 41 in the light-emitting device layer 40 are arranged in an array. That is, the plurality of anodes 43a are arranged in an array.

As shown in FIGS. 2 and 3, in the full-screen display panel 100, the display region 10a is divided into a first display region 11b and a second display region 11a. The second display region 11a may be located within the first display region 11b. That is, the first display region 11b surrounds the second display region 11a. For example, the second display region 11a is a circular region or a square region. In some embodiments, a portion of the base substrate 10 and a portion of the driving circuit layer 20 that are located in the second display region 11a each have a relatively high light transmittance. For example, the base substrate 10 is a transparent glass substrate, which provides a relatively high transparency. The driving circuit layer 20 is provided with no circuit structure in the second display region 11a therein, so as to maintain a sufficient transparency of the driving circuit layer. The base substrate 10 is provided with a sensor 200 such as an optical sensor (e.g., a camera, an optical proximity sensor or a 3D sensing module) on a side away from the driving circuit layer, and a projection of the sensor 200 on the base substrate 10 is located in the second display region 11a. The photosensitive side of the optical sensor faces a display side of the display panel 100, which is used for receiving ambient light from the display side of the display panel 100. For example, the light-emitting device layer 40 and the encapsulation layer 50 each have a transparent structure at least in the second display region 11a. For example, the anode layer 411 in the light-emitting device layer 40 is made of a transparent conductive material such as indium tin oxide (ITO) or indium zinc oxide (IZO), so that the second display region 11a has a relatively high light transmittance, and is suitable for arranging a device (e.g., the camera) having a high requirement of the transmittance. Thus, the display panel 100 may achieve full-screen display in the display region 10a. Furthermore, the optical sensor are disposed in the second display region 11a, and the optical sensor may receive external light through the light-emitting device layer 40 and the encapsulation layer 50 to achieve a respective function.

As shown in FIG. 3, in the plurality of anodes 43a included in the anode layer 43, an anode 43a located in the second display region 11a is referred to as a first-type anode 43a1, and an anode 43a located in the first display region 11b is referred to as a second-type anode 43a2. That is, the anode layer 411 includes a plurality of first-type anodes 43a1 and a plurality of second-type anodes 43a2. Similarly, in the plurality of pixel driving circuits 21 included in the driving circuit layer 20, a pixel driving circuit 21 electrically connected to the first-type anode 43a1 is referred to as a first-type pixel driving circuit 211, and a pixel driving circuit 21 electrically connected to the second-type anode 43a2 is a second-type pixel driving circuit 212. The first-type pixel driving circuit 211 and the second-type pixel driving circuit 212 are both disposed in the first display region 11b. For example, the driving circuit layer 20 further includes a plurality of second-type pixel driving circuits 212 arranged in an array in the first display region 11b, and a plurality of first-type pixel driving circuits 211 are respectively disposed in gaps of the array of the plurality of second-type pixel driving circuits 212. For example, the plurality of first-type pixel driving circuits 211 are disposed in a position of the first display region 11b proximate to the second display region 11a. That is, the plurality of first-type pixel driving circuits 211 are located on a periphery of the second display region 11a.

In some embodiments, a first-type pixel driving circuit 211 is electrically connected to a first-type anode 43a1, and a second-type pixel driving circuit 212 is electrically connected to a second-type anode 43a2. In some examples, as shown in FIG. 3, an orthographic projection, on the base substrate 10, of the second-type pixel driving circuit 212 overlaps with an orthographic projection, on the base substrate 10, of the second-type anode 43a2 electrically connected to the second-type pixel driving circuit 212; and the second-type pixel driving circuit 212 is electrically connected to the second-type anode 43a2 through via holes penetrating the planarization layer 27 and the insulating layers in the connection layer 30. In some other examples, the first-type pixel driving circuit 211 is located in the first display region 11b, and the first-type anode 43a1 is located in the second display region 11a, so that an orthographic projection, on the base substrate 10, of the first-type pixel driving circuit 211 is non-overlapping with an orthographic projection, on the base substrate 10, of the first-type anode 43a1 electrically connected to the first-type pixel driving circuit 211, and there is a certain distance between the two orthographic projections. Therefore, the first-type pixel driving circuit 211 is electrically connected to the first-type anode 43a1 via a connection line 31 in the connection layer 30, and each connection line 31 connects the first display region 11b and the second display region 11a. As a result, it is achieved that a current signal from the first-type pixel driving circuit 211 located in the first display region 11b is transmitted to the first-type anode 43a1 located in the second display region 11a, so as to control a light-emitting device 41 in which the first-type anode 43a1 is located to emit light. Thus, a requirement of normal display of an image of the full-screen display panel 100 and a requirement of a high light transmittance of the optical sensor (e.g., the camera) located in the non-display side of the display panel 100 are both satisfied.

As shown in FIGS. 3 and 4, in an example where the display apparatus 1000 is the mobile phone, in the display panel 100, the second display region 11a is the circular region, a diameter of the second display region 11a is approximately 2.5 mm in general, and this region is provided with an under-screen camera therein. Considering the display panel 100 of the mobile phone as an example, light-emitting devices in the second display region 11a are arranged in 40 rows by 80 columns. In the related art, each first-type anode 43a1 is electrically connected to a respective first-type pixel driving circuit 211 via a respective connection line 31, and the respective connection line 31 transmits a driving current signal output by the respective first-type pixel driving circuit 211. That is, the number of connection lines 31 is equal to the number of first-type anodes 43a1. As a result, in a case where the number of connection lines 31 is relatively great, since the connection lines 31 need to be insulated from one another, it is necessary to arrange the connection lines 31 in a plurality of conductive layers, respectively.

For example, as for a connection manner as shown in FIG. 4, in a case where the first-type pixel driving circuits 211 are disposed in the first display region 11b and are respectively located on two sides of the second display region 11a in a first direction (a row direction in which the plurality of first-type anodes are arranged in an array), considering a row (a diameter passing through the circular region), in which the number of light-emitting devices 41 is the greatest, in the second display region 11a as an example, this row includes 80 light-emitting devices 41, so that it is necessary to transversely arrange 80 connection lines 31 to satisfy the control requirement. In view of a requirement of a width of the connection line 31 and a requirement of which the connection lines 31 need to be insulated from one another, since the number of connection lines 31 is relatively great, it is necessary to evenly arrange the 80 connection lines 31 in three conductive layers (as shown in FIG. 3). The number of connection lines 31, that are arranged in each conductive layer, of the 80 connection lines 31 is described as follows: each conductive layer includes 26 to 30 connection lines 31 that are parallel to one another. It is necessary to provide an insulating layer for insulating between every two adjacent conductive layers and an insulating layer for insulating between the conductive layer and the anode layer (a total of three insulating layers). That is, the full-screen display panel needs to additionally provide three conductive layers and three insulating layers, and a relatively great number of conductive layers and a relatively great number of insulating layers will reduce the light transmittance in the second display region 11a. In addition, it is necessary to additionally provide six masks in a manufacturing process in order to manufacture the three conductive layers and the three insulating layers, which may increase a process difficulty, reduce a production efficiency and increase a cost, so that a capacity demand cannot be satisfied.

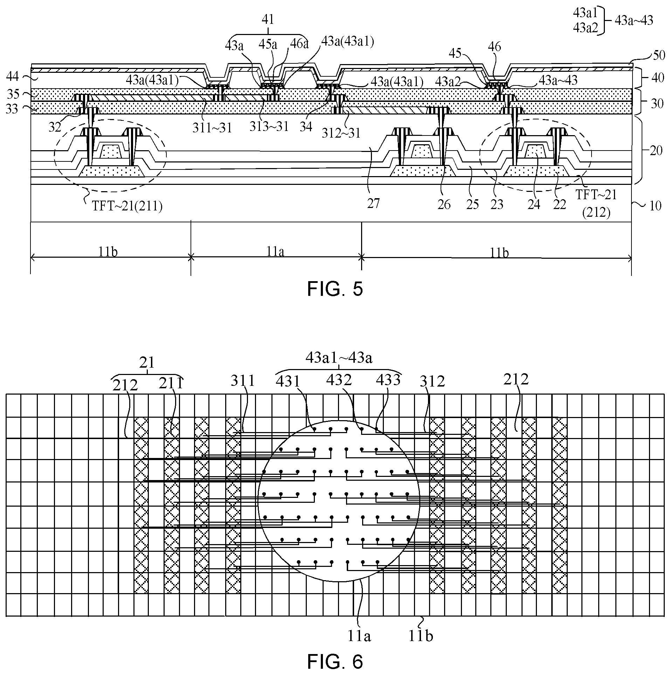

In light of this, as shown in FIGS. 5 and 6, FIG. 5 illustrates a section view of the display panel 100, and FIG. 6 illustrates the anodes 43a in the first display region 11b, and the plurality of first-type pixel driving circuits 211 and the second-type pixel driving circuits 212 in the second display region 11a. Some embodiments of the present disclosure provide a display panel 100 including a base substrate 10, a driving circuit layer 20, a connection layer 30, a light-emitting device layer 40 and an encapsulation layer 50, and a structure and a location of each film layer is as described above, which will not be repeated here. In the light-emitting device layer 40, an anode layer 43 includes a plurality of anodes 43a. The plurality of anodes 43a include a plurality of first anodes 431, a plurality of second anodes 432 and a plurality of third anodes 433; the first anode 431, the second anode 432 and the third anode 433 respectively correspond to sub-pixels of different colors; anodes 43a, that are located in the second display region 11a, in the plurality of first anodes 431, the plurality of second anodes 432 and the plurality of third anodes 433 are classified as first-type anodes 43a1. Structures of the second-type anode 432 located in the first display region 11b and the second-type pixel driving circuit 212 located in the first display region 11b are the same as a general arrangement. Hereinafter, a structure of the first-type anode 43a1 in the second display region 11a, and an electrical connection manner between the first-type anode 43a1 and the respective first-type pixel driving circuit 211 are described.

As shown in FIGS. 5 and 6, the plurality of connection lines 31 in the connection layer 30 include a plurality of first lines 311. The plurality of first-type anodes 43a1 include the plurality of first anodes 431, and at least two first anodes 431 are electrically connected to a first-type pixel driving circuit 211 via a first line 311. For example, two adjacent first anodes 431 are electrically connected to a first-type pixel driving circuit 211 via a first line 311. As shown in FIG. 5, in the first-type anodes 43a1 located in the second display region 11a, a first first-type anode 43a1 and a second first-type anode 43a1 from the left are the first anodes 431, and it can be seen that the two first anodes 431 are electrically connected to a first-type pixel driving circuit 211 via a first line 311.

In some embodiments, as shown in FIG. 6, a plurality of first-type anodes 43a1 further include second anodes 432 and third anodes 433; the connection lines 31 further include a plurality of second lines 312. A second anode 432 is electrically connected to a first-type pixel driving circuit 211 via a second line 312, a third anode 433 is electrically connected to another first-type pixel driving circuit 211 via another second line 312, and there is a second-type pixel driving circuit 212 between the two first-type pixel driving circuits 211.

In the display panel 100, the plurality of first lines 311 are provided, so that the two first anodes 431 are electrically connected to the single first-type pixel driving circuit 211 via the first line 311. In this way, the single first-type pixel driving circuit 211 controls the two first anodes 431. That is, the single first-type pixel driving circuit 211 drives two light-emitting devices 41 to emit light. Furthermore, the second anode 432 and the third anode 433 are each electrically connected to a respective first-type pixel driving circuit 211 via a respective second line 312. In this way, on a basis of ensuring a display effect, the number of connection lines 31 is reduced, so that the number of conductive layers in the connection layer 30 and the number of insulating layers in the connection layer 30 may be each reduced accordingly. For example, in a case where an area of the second display region 11a is constant (that is, the number of the anodes 43a in the second display region 11a is constant), since the number of the first lines 31 is reduced, the number of conductive layers in the connection layer 30 and the number of insulating layers in the connection layer 30 may be each reduced from three in the related art to two. Thus, in a manufacturing process of the display panel 100, it is possible to reduce the number of masks needed to be used for manufacturing the conductive layers and the insulating layers. For example, the number of masks is reduced from six in the related art to four, thereby decreasing a cost and reducing a process complexity. In addition, the number of conductive layers and the number of insulating layers are reduced, which may improve the light transmittance in the second display region 11a, so that it is conducive to a normal operation of the optical sensor in this region.

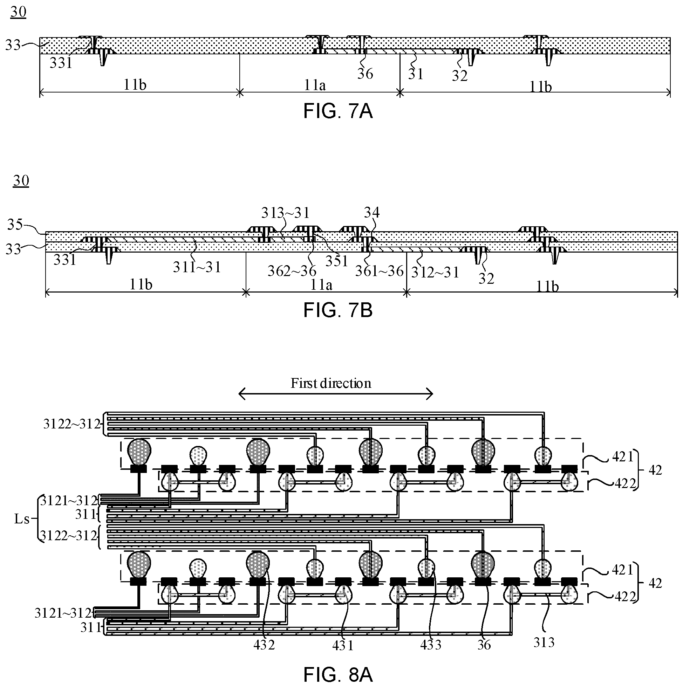

In some examples, as shown in FIG. 5, the display panel 100 includes the base substrate 10, the driving circuit layer 20, the connection layer 30, the light-emitting device layer 40 and the encapsulation layer 50. The connection layer 30 is located on a side of the driving circuit layer 20 away from the base substrate 10, and the connection layer 30 includes at least one conductive layer and at least one insulating layer. For example, as shown in FIG. 7A, the connection layer 30 includes a first conductive layer 32 and a first insulating layer 33. Alternatively, as shown in FIG. 7B, the connection layer 30 includes a first conductive layer 32, a first insulating layer 33, a second conductive layer 34 and a second insulating layer 35. The first conductive layer 32 includes the plurality of connection lines 31. Alternatively, the first conductive layer 32 and the second conductive layer 34 include the plurality of connection lines 31. The plurality of connection lines 31 include the first lines 311 and the second lines 312.

It will be noted that the above examples represent only a possible positional relationship of the connection layer 30, and do not specifically limit a relative positional relationship between the connection layer 30 and the driving circuit layer 20. In some embodiments, the connection layer 30 may be located in the driving circuit layer. That is, a certain layer in the driving circuit layer also serves as the connection layer, so as to achieve an electrical connection between the anodes and respective pixel driving circuits.

The light-emitting device layer 40 is located on a side of the connection layer 30 away from the base substrate 10, and the light-emitting device layer 40 includes a light-emitting device 41 of a green sub-pixel, a light-emitting device 41 of a red sub-pixel and a light-emitting device 41 of a blue sub-pixel. An anode 43a of the light-emitting device 41 of the green sub-pixel, an anode 43a of the light-emitting device 41 of the red sub-pixel and an anode 43a of the light-emitting device 41 of the blue sub-pixel are all disposed in the anode layer 43. The anodes 43a located in the first display region 11b are the second-type anodes 43a2, and the anodes 43a located in the second display region 11a are the first-type anodes 43a1. Each second-type anode 43a2 is electrically connected to a second-type pixel driving circuit 211. In the first-type anodes 43a1, the anode 43a of the light-emitting device 41 of the green sub-pixel is the first anode 431, the anode 43a of the light-emitting device 41 of the red sub-pixel is the second anode 432, and the anode 43a of the light-emitting device 41 of the blue sub-pixel is the third anode 433; alternatively, the anode 43a of the light-emitting device 41 of the green sub-pixel is the first anode 431, the anode 43a of the light-emitting device 41 of the blue sub-pixel is the second anode 432, and the anode 43a of the light-emitting device 41 of the red sub-pixel is the third anode 433. Two first anodes 431 are electrically connected to a first-type pixel driving circuit 211 via a first line 311, the second anode 432 is electrically connected to another first-type pixel driving circuit 211 via a second line 312, and the third anode 433 is electrically connected to yet another first-type pixel driving circuit 211 via another second line 312. That is, the first-type pixel driving circuit 211 drives the two light-emitting devices 41 of green sub-pixels to emit light, and the another first-type pixel driving circuit 211 drives the light-emitting device of the red sub-pixel or the light-emitting device of the blue sub-pixel to emit light.

In some embodiments, as shown in FIG. 7B, the connection layer 30 includes the first conductive layer 32, the first insulating layer 33, the second conductive layer 34 and the second insulating layer 35. The first conductive layer 32 is disposed on the side of the driving circuit layer 20 away from the base substrate 10, the first insulating layer 33 is disposed on a side of the first conductive layer 32 away from the base substrate 10, the second conductive layer 34 is disposed on a side of the first insulating layer 33 away from the base substrate 10, and the second insulating layer 35 is disposed on a side of the second conductive layer 34 away from the base substrate 10. The first conductive layer 32 includes first lines 311 and/or second lines 312, and the second conductive layer 34 includes first lines 311 and/or second lines 312. The first insulating layer 33 has first via holes 331 therein, the second insulating layer 35 has second via holes 351 therein, the first conductive layer 32 is electrically connected to the second conductive layer 34 through the first via holes 331, and the second conductive layer 34 is electrically connected to the anode layer 43 through the second via holes 351.

For example, the first conductive layer 32, the first insulating layer 33, the second conductive layer 34 and the second insulating layer 35 are disposed in the display region 10a, the first conductive layer 32 and the second conductive layer 34 are provided with the plurality of connection lines 31 therein, and each conductive layer is insulated from another layer by an insulating layer. In the second display region 11a, the optical sensor is disposed on the side of the connection layer 30 away from the light-emitting device layer 40, and the first conductive layer 32, the first insulating layer 33, the second conductive layer 34 and the second insulating layer 35 are each a transparent structure, which may satisfy a requirement of the light transmittance of the optical sensor.

In some other embodiments, as shown in FIG. 7A, the connection layer 30 includes the first conductive layer 32 and the first insulating layer 33. The first conductive layer 32 is disposed on the side of the driving circuit layer 20 away from the base substrate 10. The first insulating layer 33 is disposed on a side of the first conductive layer 32 away from the base substrate 10. The first conductive layer 32 includes the plurality of connection lines 31, the first insulating layer 33 has first via holes 331 therein, and the first conductive layer 32 is electrically connected to the anode layer 43 through the first via holes 331.

For example, the first conductive layer 32 is disposed in the display region 10a, and the plurality of connection lines 31 are disposed in the first conductive layer 32; the first insulating layer 33 is disposed on the side of the first conductive layer 32 away from the base substrate 10, so that the first conductive layer 32 is insulated from the anode layer by the first insulating layer 33. In the second display region 11a, the optical sensor is disposed on the side of the connection layer 30 away from the light-emitting device layer 40, and the first conductive layer 32 and the first insulating layer 33 are each a transparent structure, which may satisfy a requirement of the light transmittance of the optical sensor.

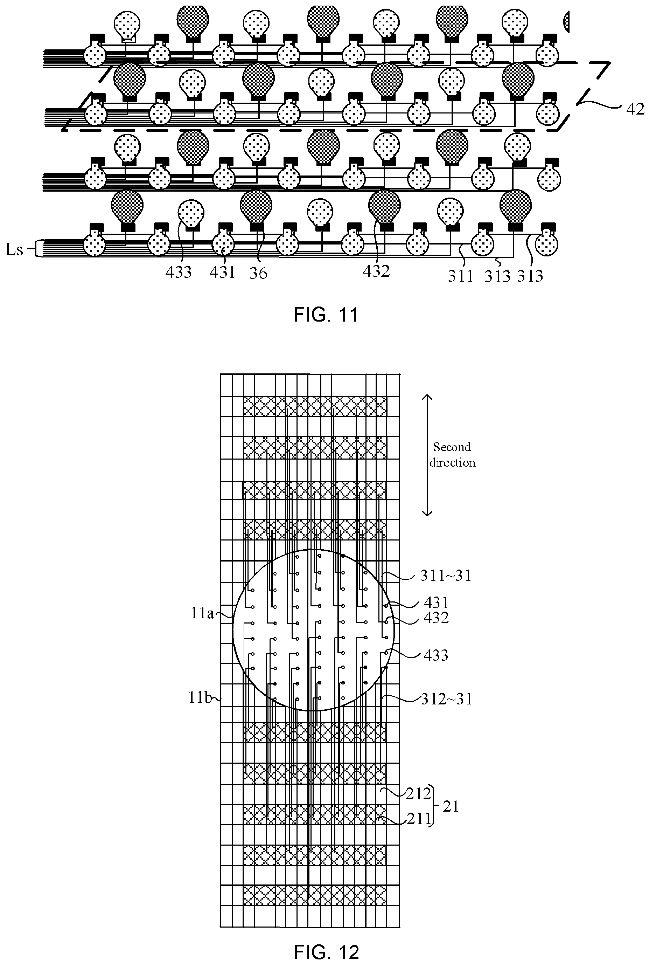

In some embodiments, as shown in FIG. 11, an arrangement manner of the plurality of first-type anodes is that, the plurality of first-type anodes are arranged in a plurality of rows, first-type anodes arranged in a row are referred to as a first-type anode row 42, at least one first-type anode row 42 includes at least two first anodes 431, at least one second anode 432 and at least one third anode 433 that are arranged in a row. The at least two first anodes 431 in the at least one first-type anode row 42 are electrically connected to a single first line 311.

In some examples, as shown in FIGS. 8A, 9A, 10Aand 11, the first-type anodes in the first-type anode row 42 are cyclically arranged according to an order of a second anode 432, a first anode 431, a third anode 433 and a first anode 431.

For example, the plurality of first-type anodes are arranged in a plurality of rows, each first-type anode row 42 includes a first sub-row 421 and a second sub-row 422 that are parallel to each other, second anodes 432 and third anodes 433 are alternately arranged in the first sub-row 421, and first anodes 431 are sequentially arranged in the second sub-row 422. The number of first anodes 431 in the second sub-row 422 is equal to a sum of the number of second anodes 432 in the second sub-row 422 and the number of third anodes 433 in the second sub-row 422, and a first anode 431 is disposed at a central axis of a second anode 432 and a third anode 433 that are adjacent to the first anode 431. The first anode 431 is the anode of the light-emitting device of the green sub-pixel, the second anode 432 is the anode of the light-emitting device of the blue sub-pixel, and the third anode 433 is the anode of the light-emitting device of the red sub-pixel. Alternatively, the first anode 431 is the anode of the light-emitting device of the green sub-pixel, the second anode 432 is the anode of the light-emitting device of the red sub-pixel, and the third anode 433 is the anode of the light-emitting device of the blue sub-pixel. Thus, a single first line 311 transmits a signal to light-emitting devices of two green sub-pixels.

As shown in FIG. 11, the plurality of first-type anodes are arranged in the plurality of rows; the plurality of connection lines 31 are arranged to constitute a plurality of line groups Ls, and a line group Ls includes at least one first line 311 and at least two second lines 312. The plurality of connection lines 31 each extend in a first direction, and the first direction is a row direction in which anodes are arranged. A connection relationship between the line group Ls and the first-type anode row 42 will be described below.

In some examples, as shown in FIG. 8A, in the line group Ls, a single first line 311 is connected to two first anodes 431 in a first-type anode row 42; the at least two second lines 312 in the line group Ls include at least one first sub-line 3121 and at least one second sub-line 3122, a first sub-line 3121 is connected to a second anode 432 or a third anode 433 in the first-type anode row 42, and a second sub-line 3122 is connected to a second anode 432 or a third anode 433 in another first-type anode row 42 adjacent to the first-type anode row 42.

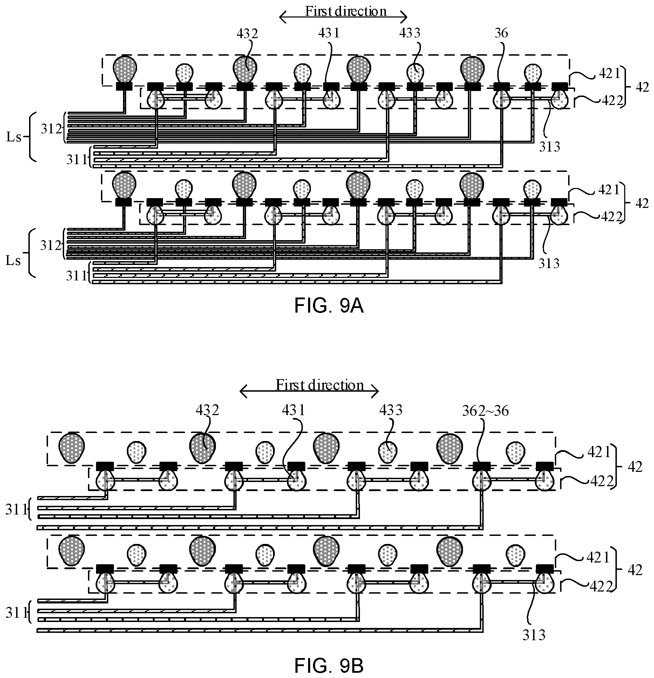

In some other examples, as shown in FIG. 9A, in the line group Ls, a single first line 311 is connected to two first anodes 431 in a first-type anode row 42, and a single second line 312 is connected to a second anode 432 or a third anode 433 in the first-type anode row 42. At least one first-type anode row 42 is electrically connected to first-type pixel driving circuits via a line group Ls, and the line group Ls includes multiple first lines 311 and multiple second lines 312.

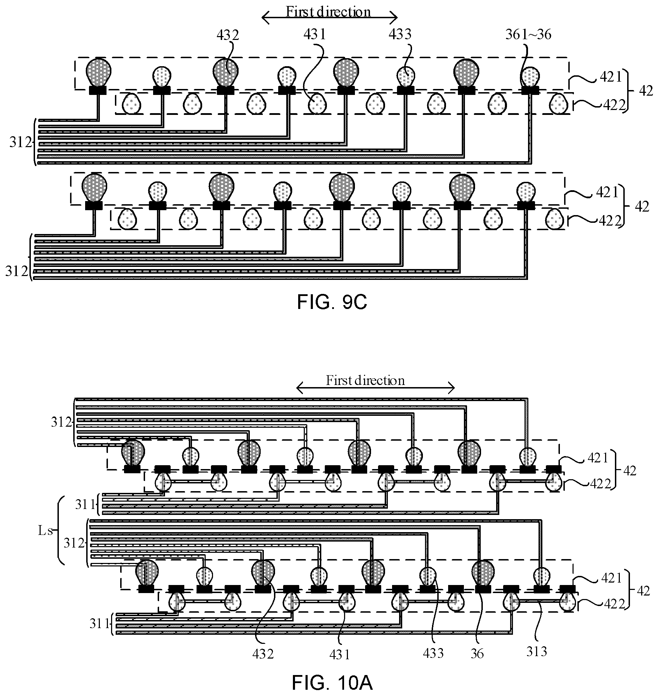

In yet other examples, as shown in FIG. 10A, in the line group Ls, a single first line 311 is connected to two first anodes 431 in a first-type anode row 42, and a single second line 312 is connected to a second anode 432 or a third anode 433 in another first-type anode row 42. For example, the another first-type anode row 42 may be adjacent to the first-type anode row 42. That is, the single line group Ls is connected to two first-type anode rows 42. As for a first-type anode row 42, a first anode 431 in the first-type anode row 42 is connected to a first line 311 in a line group Ls, and a second anode 432 or a third anode 433 is connected to a second line 412 in another line group Ls. At least one first-type anode row 42 is electrically connected to first-type pixel driving circuits via two line groups Ls. For example, the line group Ls is located between the two adjacent first-type anode rows 42.

Only part of examples of the connection relationship between the line group Ls and the first-type anode row 42 are described above, and there are other examples, as long as a requirement of which the single first line 311 is connected to the two first anodes 431 and the single second line 312 is connected to the second anode 432 or the third anode 433 can be satisfied, and the fact that the single first line 311 transmits a signal to the light-emitting devices of the two green sub-pixels, and the single second line 312 transmits another signal to the light-emitting device of the blue sub-pixel or the light-emitting device of the red sub-pixel is achieved. The above examples do not limit a connection manner between the connection line and the anode in the present disclosure.

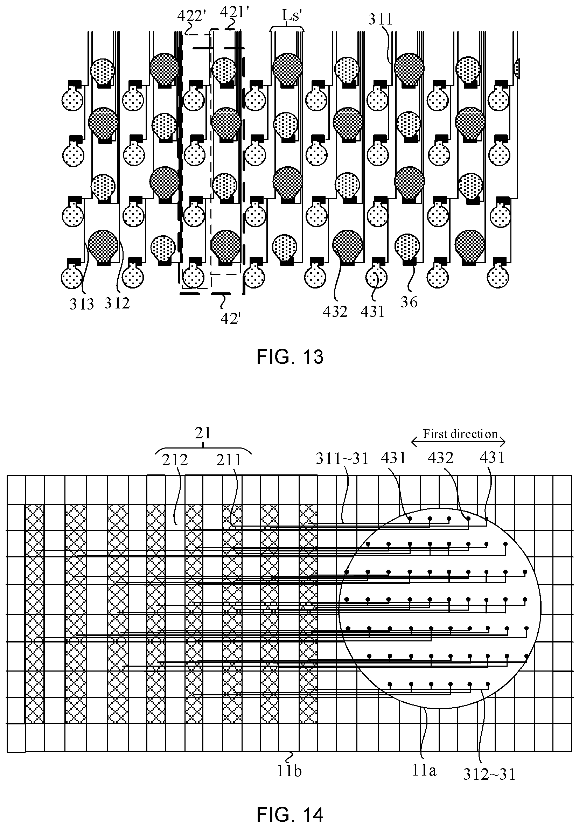

In some other embodiments, as shown in FIGS. 12 and 13, another arrangement manner of the plurality of first-type anodes is that, the plurality of first-type anodes are arranged in a plurality of columns, first-type anodes arranged in a column are referred to as a first-type anode column 42' below, at least one first-type anode column 42' includes at least two first anodes 431, at least one second anode 432 and at least one third anode 433 that are arranged in a column. At least two first anodes 431 in a first-type anode column 42' are electrically connected to a first line 311.

In some examples, the first-type anodes in the first-type anode column 42' are cyclically arranged according to an order of a second anode 432, a first anode 431, a third anode 433 and a first anode 431.

For example, the plurality of first-type anodes are arranged in a plurality of columns, each first-type anode column 42' includes a first sub-column 421' and a second sub-column 422' that are parallel to each other, second anodes 432 and third anodes 433 are alternately arranged in the first sub-column 421', and first anodes 431 are sequentially arranged in the second sub-column 422'. The number of the first anodes 431 in the second sub-column 422' is equal to a sum of the number of the second anodes 432 in the first sub-column 421' and the number of the third anodes 433 in the first sub-column 421', and each first anode 431 is disposed at a central axis of a second anode 432 and a third anode 433 that are adjacent to the first anode 431. The first anode 431 is the anode of the light-emitting device of the green sub-pixel, the second anode 432 is the anode of the light-emitting device of the blue sub-pixel, and the third anode 433 is the anode of the light-emitting device of the red sub-pixel. Alternatively, the first anode 431 is the anode of the light-emitting device of the green sub-pixel, the second anode 432 is the anode of the light-emitting device of the red sub-pixel, and the third anode 433 is the anode of the light-emitting device of the blue sub-pixel. Thus, a single first line 311 transmits a signal to light-emitting devices of two green sub-pixels.

As shown in FIG. 13, the plurality of first-type anodes are arranged in the plurality of columns; the plurality of connection lines 31 are arranged to constitute a plurality of line groups Ls', and each line group Ls' includes at least one first line 311 and at least two second lines 312. The plurality of connection lines 31 each extend in a second direction, and the second direction is a column direction in which anodes are arranged. A connection relationship between the line group Ls' and the first-type anode column will be described below, which may refer to the description and related accompanying drawings of the connection relationship between the line group Ls and the first-type anode row.

In some examples, in the line group Ls', a single first line 311 is connected to two first anodes 431 in a first-type anode column 42', and a single second line 312 is connected to a second anode 432 or a third anode 433 in the first-type anode column 42'. At least one first-type anode column 42' is electrically connected to first-type pixel driving circuits 21 via a line group Ls', and the line group Ls' includes multiple first lines 311 and multiple second lines 312. Thus, the first line 311 transmits a signal to the light-emitting devices of the two green sub-pixels, and the second line 312 transmits another signal to the light-emitting device of the blue sub-pixel or the light-emitting device of the red sub-pixel.

In some other examples, in the line group Ls', a single first line 311 is connected to two first anodes 431 in a first-type anode column 42'; the at least two second lines 312 in the line group Ls' include at least one first sub-line and at least one second sub-line, the at least one first sub-line is connected to a second anode 432 or a third anode 433 in the first-type anode column 42', and each second sub-line is connected to a second anode 432 or a third anode 433 in another first-type anode column 42' adjacent to the first-type anode column 42'.

In yet other examples, in the line group Ls', a first line 311 is connected to two first anodes 431 in a first-type anode column 42', and a second line 312 is connected to a second anode 432 or a third anode 433 in another first-type anode column 42'. For example, the another first-type anode column 42' may be adjacent to the first-type anode column 42'. That is, the single line group Ls' is connected to two first-type anode columns 42'. As for a first-type anode column 42', a first anode 431 in the first-type anode column 42' is connected to a first line 311 in a line group Ls', and a second anode 432 or a third anode 433 is connected to a second line 312 in another line group Ls'. At least one first-type anode column 42' is electrically connected to first-type pixel driving circuits via two line groups Ls'. For example, the line group Ls' is located between the two adjacent first-type anode columns 42'.

Only part of examples of the connection relationship between the line group Ls' and the first-type anode column 42' are described above, and there are other examples as long as a requirement of which the single first line 311 is connected to the first anode 431 and the single second line 312 is connected to the second anode 432 or the third anode 433 can be satisfied. The above examples do not limit the connection manner between the connection line and the anode in the present disclosure.

In some embodiments, as shown in FIGS. 6, 12, 14 and 15, an arrangement of positions of the plurality of first-type pixel driving circuits 21 in the first display region 11b is that, orthographic projections of the plurality of first-type pixel driving circuits 211 on the base substrate 10 is located on one or two sides, in an extending direction of the plurality of connection lines 31, of orthographic projections of the plurality of first-type anodes 21 on the base substrate 10.

In some examples, as shown in FIG. 6, the plurality of connection lines 31 each extend in the first direction, and the plurality of first-type pixel driving circuits 211 are respectively located on two sides (e.g., a left side and a right side) of the second display region 11a. In some other examples, as shown in FIG. 14, the plurality of connection lines 31 each extend in the first direction, and the plurality of first-type pixel driving circuits 211 are located on one side (e.g., a left side) of the second display region 11a.

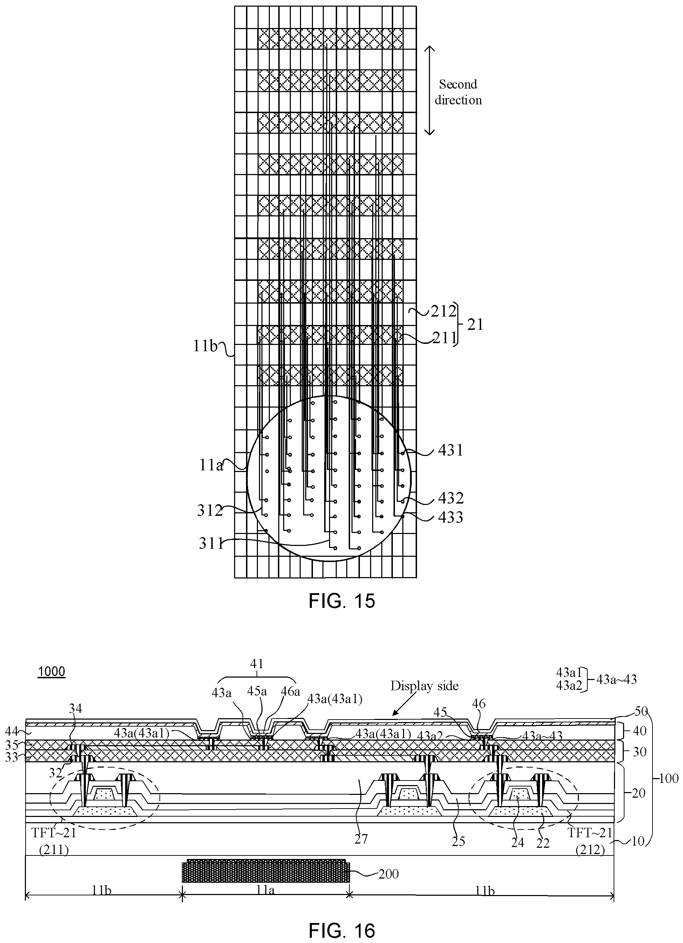

In some examples, as shown in FIG. 12, the plurality of connection lines 31 each extend in the second direction, and the plurality of first-type pixel driving circuits 211 are respectively located on two sides (e.g., an upper side and a lower side) of the second display region 11a. In some other examples, as shown in FIG. 15, the plurality of connection lines 31 each extend in the second direction, and the plurality of first-type pixel driving circuits 211 are located on one side (e.g., an upper side) of the second display region 11a.

In some embodiments, the first conductive layer 32 includes first lines 311 and/or second lines 312, and the second conductive layer 34 includes first lines 311 and/or second lines 312. Hereinafter, referring to FIGS. 8A to 10C, distributions of the first lines 311 and the second lines 312 of the line group in the first conductive layer 32 and the second conductive layer 34 are described by taking several connection relationships between the line group Ls and the first-type anode row 42 as examples.

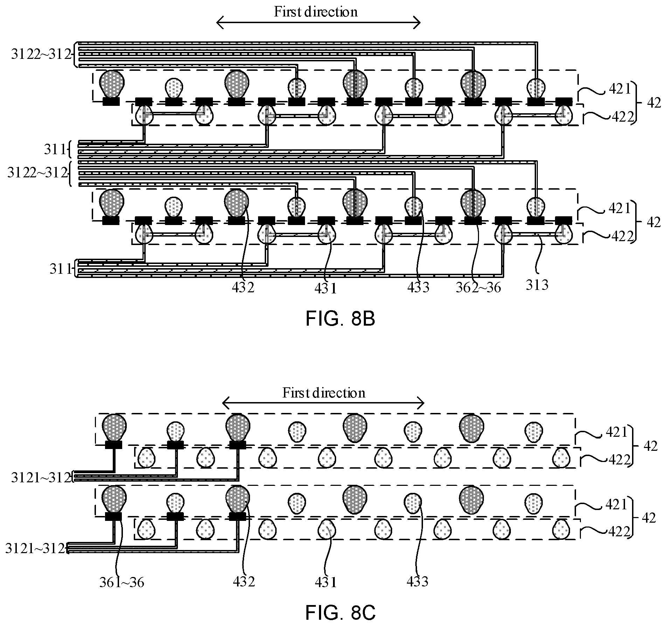

In some examples, the first lines 311 included in a single line group Ls may be located in a conductive layer, a part of the second lines 312 included in the line group Ls may be located in the conductive layer, and the other part of the second lines 312 may be located in the other conductive layer. As shown in FIGS. 6, 8A, 8B and 8C, for a convenience of a description, connection lines 31, that are located in different conductive layers, in FIG. 8A are respectively shown in two accompanying drawings; FIG. 8B is a diagram showing a connection between a part, located in the second conductive layer, of the connection lines 31 in FIG. 8A and respective first-type anodes, and FIG. 8C is a diagram showing a connection between the other part, located in the first conductive layer, of the connection lines 31 in FIG. 8A and respective first-type anodes. In the line group Ls, as shown in FIG. 8B, all of the first lines 311 are disposed in the second conductive layer 34, and a part of the second lines 312 are disposed in the second conductive layer 34; as shown in FIG. 8C, the other part of the second lines 312 are disposed in the first conductive layer. The connection lines 31 included in the line group Ls are evenly arranged in the two conductive layers, and positions of the connection lines 31 are arranged reasonably, so that a problem, caused by which a distance between adjacent connection lines 31 is too small, of a short circuit or a crosstalk may be avoided.

For example, in an example where the light-emitting devices in the second display region 11a are arranged in 40 rows by 80 columns (that is, the first-type anodes 43a1 located in the second display region 11a are arranged in 40 rows by 80 columns), as shown in FIG. 6, in a case where the second display region 11a is the circular region, a first-type anode row 42 in which the number of anodes 43a is the greatest is a row passing through the diameter of the circular region, and the number of the first-type anodes is 80; first-type pixel driving circuits 211 respectively located on two sides of the second display region 11a are electrically connected to first-type anodes 43a1 in the row via respective connection lines 31; the 80 first-type anodes 43a1 in the first-type anode row 42 are equally divided into two parts, first-type pixel driving circuits 211 located on a side of the second display region 11a are electrically connected to 40 first-type anodes 43a1 in the row, and first-type pixel driving circuits 211 located on the other side of the second display region 11a are electrically connected to other 40 first-type anodes 43a1 in the row. A specific connection manner between the first-type anode 43a1 and the connection line 31 is described by taking the first-type anode row 42 in which the number of anodes 43a is the greatest as an example.

The 40 first-type anodes 43a1 include 10 second anodes 432, 10 third anodes 433 and 20 first anodes 431, and are cyclically arranged according to an order of a first anode 431, a second anode 432, a first anode 431 and a third anode 433. Connection lines that are electrically connected to the 40 first-type anodes 43a1 include 10 first lines 311 and 20 second lines 312.

The 10 first lines 311 and 5 second lines 312 are located in the second conductive layer in which each first line 311 is connected to two first anodes 431, so that a purpose of which the 20 first anodes 431 are connected to respective first pixel driving circuits 211 is achieved. The 5 second lines 312 are located in the second conductive layer, and are electrically connected to two second anodes 432 and three third anodes 433, respectively; alternatively, the 5 second lines 312 are electrically connected to two third anodes 433 and three second anodes 432, respectively. Each second line 312 is electrically connected to a second anode or a third anode. The remaining 15 second lines 312 are located in the first conductive layer, and each second line is electrically connected to one of the remaining 15 second anodes 432 and third anodes 433 in total, so that a purpose of which the connection lines are evenly arranged in the first conductive layer and the second conductive layer is achieved.

The 5 second lines 312 located in the second conductive layer are electrically connected to the second anodes 432 and third anodes 433 from a side of the first-type anode row 42 in which the number of anodes 43a is the greatest, and the 10 first lines 311 located in the second conductive layer are electrically connected to the first anodes 431 from the other side of the first-type anode row 42 in which the number of anodes 43a is the greatest. Thus, it is possible to avoid the problem of the short circuit caused by which the first line 311 and the second line 312 intersect in a same conductive layer.

In some other examples, all of the first lines 311 in the line group Ls are located in a same conductive layer, which may be, for example, the first conductive layer or the second conductive layer. All of the second lines 312 in the line group Ls are located in another conductive layer, which may be, for example, the second conductive layer or the first conductive layer. As shown in FIGS. 9A, 9B and 9C, for the convenience of the description, connection lines, that are located in different conductive layers, in FIG. 9A are respectively shown in two accompanying drawings; FIG. 9B is a diagram showing a connection between a part, located in the second conductive layer, of the connection lines 31 in FIG. 9A and respective first-type anodes, and FIG. 9C is a diagram showing a connection between the other part, located in the first conductive layer, of the connection lines 31 in FIG. 9A and respective first-type anodes. As shown in FIG. 9B, all of the first lines 311 in the line group Ls are located in the second conductive layer 34. As shown in FIG. 9C, all of the second lines 312 in the line group Ls are located in the first conductive layer 32.

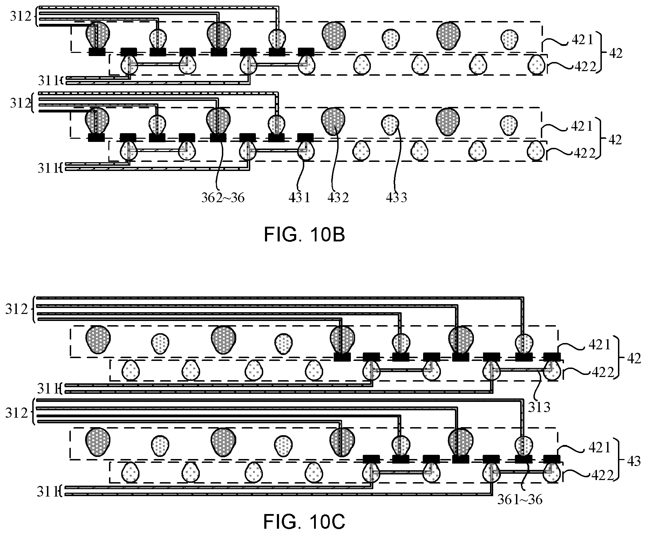

In yet other examples, in the line group Ls, a part of the first lines 311 and a part of the second lines 312 are located in a same conductive layer, and the other part of the first lines 311 and the other part of the second lines 312 are located in another conductive layer. As shown in FIGS. 10A, 10B and 10C, for the convenience of the description, connection lines, that are located in different conductive layers, in FIG. 10A are respectively shown in two accompanying drawings; FIG. 10B is a diagram showing a connection between a part, located in the second conductive layer, of the connection lines 31 in FIG. 10A and respective first-type anodes, and FIG. 10C is a diagram showing a connection between the other part, located in the first conductive layer, of the connection lines 31 in FIG. 10A and respective first-type anodes. In the line group Ls, as shown in FIG. 10B, a part of the first lines 311 and a part of the second lines 312 are all disposed in the second conductive layer 34; as shown in FIG. 10C, the other part of the first lines 311 and the other part of the second lines 312 are all disposed in the first conductive layer 32.

In the above connection manners, the 30 connection lines 31 are arranged in the two conductive layers, and the conductive layers with a sufficient number of layers may bear these connection lines 31, so that the number of connection lines in each conductive layer is relatively small, which may satisfy a requirement of which the distance between the adjacent connection lines 31 is great enough. As a result, it is conducive to processing, and the problem of the short circuit of the connection lines is not prone to occur, so that a product yield is relatively high.

It will be noted that, as shown in FIGS. 8A and 10A, in a case where first lines 311 and second lines 312 of a same line group Ls are located in a same conductive layer, the first lines 311 and the second lines 312 of the same line group Ls are connected to first-type anodes in different rows, so as to prevent the first lines 311 and the second lines 312 from intersecting in a same layer and interfering with one other.

In some embodiments, at least two first anodes 431 constitute a first anode group; in a first anode group, a second anode 432 and a third anode 433 that are adjacent to one another, a length of a first line 311 electrically connected to the first anode group is less than a length of a second line 312 electrically connected to the second anode 432, and is less than a length of a second line 312 electrically connected to the third anode 433.

In some examples, an end of the first line 311 is electrically connected to a first anode 431 in a first-type anode row 42, and the other end of the first line 311 is electrically connected to a first-type pixel driving circuit 211 proximate to the second display region 11a preferentially. An end of a second line 312 of a part of the second lines 312 is electrically connected to a second anode 432 or a third anode 433 in the first-type anode row 42, the other end of the second line 312 is connected to a first-type pixel driving circuit 211, and the first-type pixel driving circuit 211 connected to the other end of the second line 312 of all second lines 312 is farther away from the second display region 11a than the first-type pixel driving circuit 211 connected to the first line 311. Thus, in the first anode group, the second anode 432 and the third anode 433 that are adjacent to one another, the length of the first line 311 electrically connected to the first anode group is less than the length of the second line 312 electrically connected to the second anode 432, and is less than the length of the second line 312 electrically connected to the third anode 433.

A first-type pixel driving circuit 211 provides a voltage signal for two first anodes 431. In a case where a length of a first line 311 between the first-type pixel driving circuit 211 and the two first anodes 431 is too long, the first line 311 is prone to be subjected to a resistance-capacitance interference, which causes a situation where a light-emitting device, connected to the first line 311, of the green sub-pixel fails to emit light under a low gray scale to occur. Thus, in the above embodiments, the other end of the first line 311 is electrically connected to the first-type pixel driving circuit 211 proximate to the second display region 11a preferentially, which may reduce the length of the first line 311 and reduce an intensity of the resistance-capacitance interference on the first line 31, so as to ensure a normal operation of each light-emitting device of the green sub-pixel in the second display region 11a under the low gray scale.

In some embodiments, as shown in FIGS. 8A, 9A and 10A, the plurality of connection lines 31 further include a plurality of third lines 313, a third line 313 is connected to at least two first anodes 431, and a first line 311 is connected to the third line 313 and a first-type pixel driving circuit, so that the two first anodes 431 are electrically connected to the first-type pixel driving circuit. The third line 313 and the first line 311 that are connected to each other are located in a same conductive layer.

For example, a manner of which the two first anodes 431 are electrically connected to the first-type pixel driving circuit via the first line 311 is that, the two first anodes 431 are electrically connected via the third line 313, an end of the first line 311 is electrically connected to the third line 313, and the other end of the first line 311 is electrically connected to the first-type pixel driving circuit. The first line 311 may be disposed in the first conductive layer 32 or the second conductive layer 34, and the third line 313 and the first line 311 are disposed in the same conductive layer.

In some embodiments, as shown in FIGS. 8A, 9A, 10A, 7A and 7B, the conductive layer is further provided therein with connection portions 36 that are each used for being electrically connected to a connection line 31 and an anode or being electrically connected to two connection lines 31. As shown in FIG. 7B, the second conductive layer 34 further includes a plurality of second connection portions 362, and the first conductive layer 32 further includes a plurality of first connection portions 361.

Each second connection portion 362 is electrically connected to a first-type anode, and a connection line 31 located in the second conductive layer 34 is electrically connected to the first-type anode via the second connection portion 362. The first conductive layer 32 further includes the plurality of first connection portions 361, each first connection portion 361 is electrically connected to a second connection portion 362, and a connection line 31 located in the first conductive layer 32 is electrically connected to a first-type anode via the first connection portion 361 and the second connection portion 362 that are connected to each other.

In some examples, as shown in FIGS. 8A, 9A and 10A, the first-type anode row 42 includes the first sub-row 421 and the second sub-row 422 that are parallel to each other. The second sub-row 422 includes the first anodes 431 that are sequentially arranged, and centers of the first anodes 431 are located on a same straight line. The first sub-row 421 includes the second anodes and the third anodes that are alternately arranged in the first sub-row 421, and centers of the second anodes and the third anodes are located on another straight line. The plurality of second connection portions 362 are arranged in a plurality of rows, an orthographic projection, on the base substrate, of each row of second connection portions 362 is located between orthographic projections, on the base substrate, of two straight lines corresponding to a first-type anode row 42. That is, each row of second connection portions 362 is located between a first sub-row 421 and a second sub-row 422 of a first type of anode row 42.

For example, as shown in FIG. 7B, an end, located in the second display region 11a, of the connection line 31 is connected to a connection portion 36, and the connection portion 36 includes a second connection portion 362 located in the second conductive layer 24 and a first connection portion 361 located in the first conductive layer 32. An orthographic projection of the second connection portion 362 on the base substrate overlaps with an orthographic projection, on the base substrate, of a first-type anode connected thereto, so that the first-type anode is connected to the first-type anode through the second via hole 351 penetrating the second insulating layer 35. Positions of the first connection portion 361 and the second connection portion 362 that are connected to each other correspond to each other in a direction perpendicular to the display panel 100. That is, orthographic projections of the two on the base substrate 10 overlap with each other. As a result, the second connection portion 362 is connected to the first connection portion 361 through the first via hole 331 in the first insulating layer 33. Thus, the connection between the connection line 31 and the anode is enabled to be more stable by providing the connection portion 36.

In some embodiments, as shown in FIG. 10A, the plurality of first lines 311 and the plurality of third lines 313 are located in the second conductive layer; in a first line 311 and a third line 313 that are connected to each other, the third line 313 is connected to two second connection portions 362, so as to be connected to two first anodes 431; the first line 311 is connected to one of the two second connection portions 362 that are connected to each other. Of the two second connection portions 362 that are connected to each other, an orthographic projection, on the base substrate, of the one connected to the first line 311 is closer to an orthographic projection, on the base substrate, of a first-type pixel driving circuit electrically connected to the two first anodes 4321 than an orthographic projection of another on the base substrate.

For example, the first lines 311 are located in the second conductive layer 34, and the third lines 313 and the first lines 311 are located in a same conductive layer. A third line 313 is electrically connected to two first anodes 431. For example, the two first anodes 431 may be adjacent to each other. Each of the two first anodes 431 that are connected to each other corresponds to a respective second connection portion 362. That is, an orthographic projection of each first anode 431 on the second conductive layer 34 overlaps with the respective second connection portion 362. The third line 313 is disposed between the two second connection portions 362, and the third line 313 is connected to the two second connection portions 362. A first line 311 is electrically connected to one of the two second connection portions 362, so as to achieve an electrical connection between a first-type pixel driving circuit and the second connection portions 362. Of the two second connection portions 362 that are connected to each other, an orthographic projection, on the base substrate, of the one electrically connected to an end of the first line 311 is a first projection; an orthographic projection of the other on the base substrate 10 is a second projection; an orthographic projection, on the base substrate, of the first-type pixel driving circuit electrically connected to the other end of the first line 311 is a third projection. A straight-line distance between the first projection and the third projection is less than a straight-line distance between the second projection and the third projection, so that a length of the first line may be reduced.

In some other embodiments, as shown in FIGS. 7B and 8A, the plurality of first lines 311 and the plurality of third lines 313 are located in the first conductive layer 32; in a first line 311 and a third line 313 that are connected to each other, the third line 313 is connected to two first connection portions 361 (e.g., two first connection portions 361 that may be adjacent to each other), so as to be connected to two first anodes 431; the first line 311 is connected to one of the two first connection portions 361. Of the two first connection portions 361 that are connected to each other, an orthographic projection, on the base substrate, of the one connected to the first line 311 is closer to an orthographic projection, on the base substrate, of a first-type pixel driving circuit electrically connected to the two first anodes 431 than an orthographic projection of another on the base substrate.

For example, the first lines 311 are located in the first conductive layer 32, and the third lines 313 and the first lines 311 are located in a same conductive layer. A third line 313 is electrically connected to two first anodes 431. Each of the two first anodes 431 corresponds to a respective first connection portion 361 and a respective second connection portion 362. That is, an orthographic projection of the first anode 431 on the second conductive layer 34 overlaps with the respective second connection portion 362, and an orthographic projection of the first anode 431 on the first conductive layer 32 overlaps with the respective first connection portion 361. The respective first connection portion 361 is electrically connected to the respective second connection portion 362 through a via hole; the two first connection portions 361 are connected via the third line 313, and the third line 313 is connected to the two second connection portions 362. A first line 311 is electrically connected to one of the two first connection portions 361, so as to achieve an electrical connection between the first-type pixel driving circuit and the first connection portion 361. Of the two first connection portions 361 that are connected to each other, an orthographic projection, on the base substrate, of the one electrically connected to an end of the first line 311 is a first projection'; an orthographic projection of the other on the base substrate is a second projection'; an orthographic projection, on the base substrate 10, of the first-type pixel driving circuit electrically connected to the other end of the first line 311 is a third projection'. A straight-line distance between the first projection' and the third projection' is less than a straight-line distance between the second projection' and the third projection', so that a length of the first line 311 may be reduced.

With the above arrangements, the length of each first line 311 may be reduced. As a result, the stability of the transmission of the current signal by the first line 311 may be improved, so as to ensure the normal operation of the light-emitting device of the green sub-pixel in the second display region 11a.

In some embodiments, the first line 311, the second line 312 and the third line 313 each include a transparent conductive material. For example, a material of the first line 311, a material of the second line 312 and a material of the third line 313 may be each made of ITO or IZO.

In some embodiments, the insulating layer includes a transparent insulating material. For example, a material of the first insulating layer 33 or a material of the second insulating layer 35 may be made of polyimide (PI).

It will be noted that in a case where the area of the second display region 11a is relatively small or the process accuracy of manufacturing the connection line 31 is relatively high, and the width of the connection line 31 may be further reduced, all of the connection lines 31 may be disposed in a single conductive layer. That is, the connection layer shown in FIG. 7A includes only a single conductive layer and a single insulating layer. In this way, the number of masks needed to be used in the manufacturing process may be further reduced. As a result, the process is simplified, the light transmittance in the second display region 11a is improved, and an overall thickness of the display panel 100 is reduced, so that a light weight and a small thickness of the display panel 100 are achieved.

The present disclosure further provides a display apparatus 1000. As shown in FIG. 16, the display apparatus 1000 includes the display panel 100 as provided in any one of the above embodiments and at least one sensor 200, the sensor 200 is disposed on the non-display side of the display panel 100, and an orthographic projection of the sensor 200 on the display panel 100 is located in the second display region 11a. The sensor 200 is an optical sensor 200.

In some embodiments, the at least one sensor 200 is the optical sensor 200 such as a front-facing camera, an optical proximity sensor or a 3D sensing module. For example, the display apparatus 1000 includes the display panel 100 and the front-facing camera disposed on the non-display side of the display panel 100, and the base substrate 10 and the driving circuit layer 20 of the display panel 100 each include a light-transmitting structure in the second display region 11a. For example, the second display region 11a is a circular region, the display panel 100 is entirely transparent in the second display region 11a, an orthographic projection of the front-facing camera on the display panel 100 is located in the second display region 11a, and a photosensitive side of the front-facing camera faces a display side of the display apparatus 100. The front-facing camera performs an image acquisition operation through the transparent second display region 11a.

In some examples, the display apparatus 1000 further includes a frame, a circuit board, a display driver integrated circuit (IC) and other electronic accessories, and the display panel 100 is disposed in the frame.

The display apparatus 1000 provided in the embodiments of the present disclosure may be any apparatus that displays text or images whether in motion (e.g., a video) or stationary (e.g., a still image). The display apparatus 1000 may be a mobile phone, a computer, a camera, a video player, a video camera, a game console, a watch, a clock, a calculator, a television monitor, a flat panel display, etc.

The display panel 100 provided in the present disclosure is the display panel 100 provided in the above embodiments and has beneficial effects the same as that of the display panel 100 described above, which will not be repeated here.

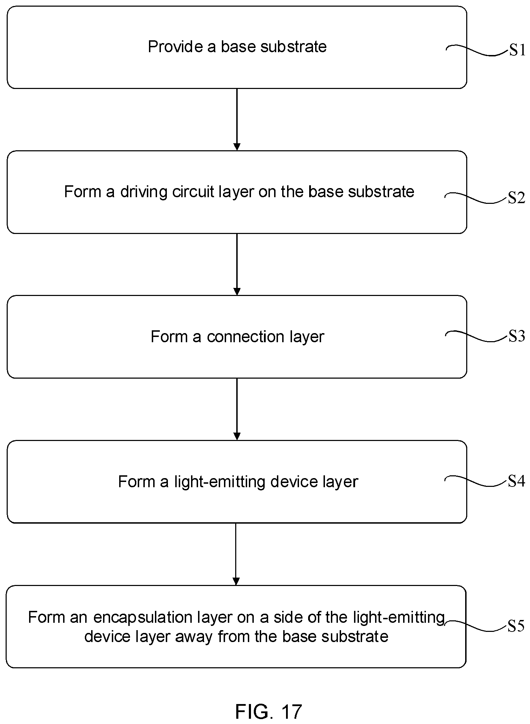

The present disclosure further provides a method of manufacturing a display panel 100. As shown in FIG. 17, the method of manufacturing the display panel 100 includes S1 to S5.

In S1, a base substrate 10 is provided.

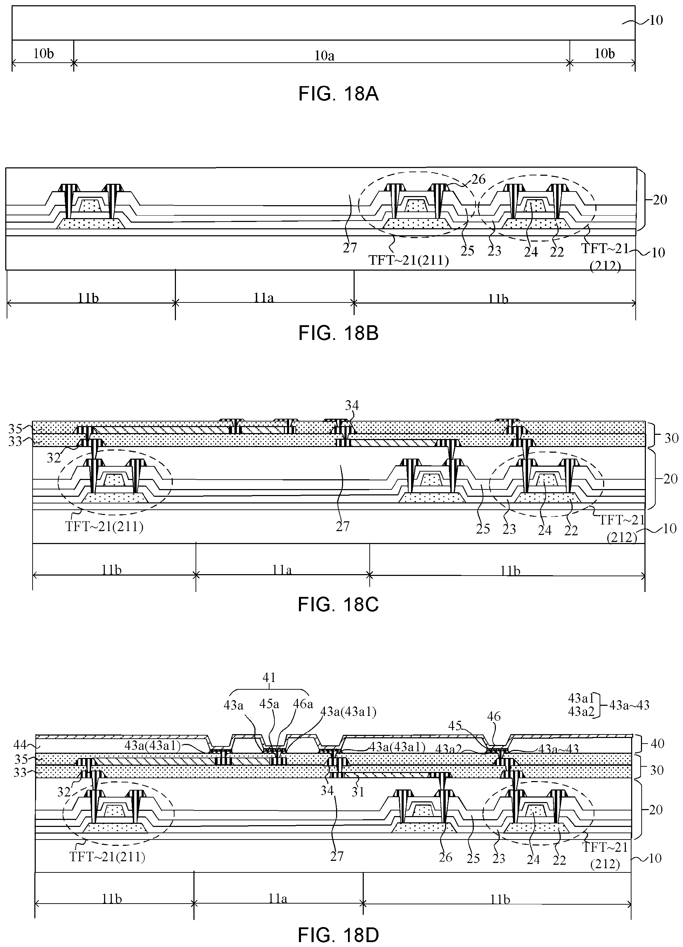

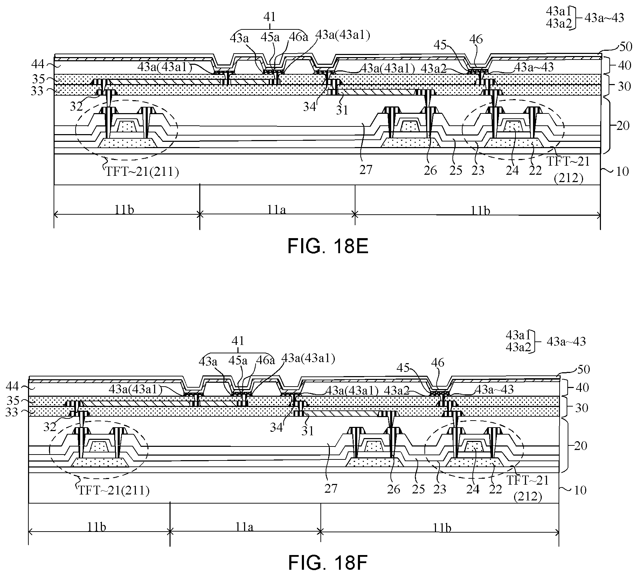

For example, as shown in FIG. 18A, the base substrate 10 may be a silicon substrate or a glass substrate, and the base substrate 10 includes a peripheral region 10b and a display region 10a. The display region 10a is divided into a first display region 11b and a second display region 11a.

In S2, a driving circuit layer 20 is formed on the base substrate 10. The driving circuit layer 20 includes a plurality of first-type pixel driving circuits, and the plurality of first-type pixel driving circuits are disposed in the first display region 10a.

For example, as shown in FIG. 18B, a semiconductor layer 22, a gate insulating layer 23, a gate layer 24, an interlayer insulating layer 25, a source-drain metal layer 26 and a planarization layer 27 are sequentially formed on the base substrate 10, and these film layers are each formed by using a deposition process and a patterning process that are general. For example, a semiconductor material layer is deposited on the base substrate 10, and the semiconductor material layer is patterned by using an etching process, so that the semiconductor layer 22 is formed. Manufacturing processes of the gate insulating layer 23, the gate layer 24, the interlayer insulating layer 25, the source-drain metal layer 26 and the planarization layer 27 may refer to a manufacturing process of the semiconductor layer 22. The semiconductor layer 22, the gate insulating layer 23, the gate layer 24, the interlayer insulating layer 25, the source-drain metal layer 26 and the planarization layer 27 constitute the driving circuit layer 20. The driving circuit layer 20 includes the plurality of first-type pixel driving circuits 211 and a plurality of second-type pixel driving circuits 212, the first-type pixel driving circuits 211 and the second-type pixel driving circuits 212 are all disposed in the first display region 11b, and the first-type pixel driving circuits 211 may be respectively manufactured in gaps of an array of the second-type pixel driving circuits 212 by using a pixel compression process.

In S3, a connection layer 30 is formed. The connection layer 30 includes a plurality of connection lines 31. The plurality of connection lines 31 include first lines 311, and further include a plurality of second lines 312.

As shown in FIG. 18C, in some embodiments, the connection layer 30 is disposed on a side of the driving circuit layer 20 away from the base substrate 10. In S3, a conductive layer and an insulating layer are sequentially formed on the side of the driving circuit layer 20 away from the base substrate 10, and respective patterns is formed in each of the conductive layer and the insulating layer. For example, the plurality of connection lines are formed in the conductive layer. For example, a first conductive layer 32, a first insulating layer 33, a second conductive layer 34 and a second insulating layer 35 are sequentially formed on the side of the driving circuit layer 20 away from the base substrate 10.

In S4, a light-emitting device layer 40 is formed. The light-emitting device layer 40 includes a pixel definition layer 44, an anode layer 43, a light-emitting film layer 45 and a cathode layer 46; the anode layer 43 includes a plurality of anodes 43a. A plurality of light-emitting devices 41 in the light-emitting device layer 40 are arranged in an array. That is, the plurality of anodes 43a are arranged in an array.

As shown in FIG. 18D, S4 includes S41. In S41, the anode layer 43 is formed on a side of the connection layer 30 away from the base substrate 10. The anode layer 43 includes a plurality of first-type anodes 43a1 located in the second display region 11a, and the plurality of first-type anodes 43a1 include a plurality of first anodes 431, a plurality of second anodes 432 and a plurality of third anodes 433. Two adjacent first anodes 431 are electrically connected to a first-type pixel driving circuit 211 via a first line 311, each second anode 432 is electrically connected to another first-type pixel driving circuit 211 via a second line 312, and each third anode 433 is electrically connected to yet another first-type pixel driving circuit 211 via another second line 312. Similarly, the anode layer 43 further includes a plurality of second-type anodes 43a2 located in the first display region 11b, and the plurality of second-type anodes 43a2 include first anodes, second anodes and third anodes. An arrangement manner of the plurality of first-type anodes 43a1 is consistent with an arrangement manner of the plurality of second-type anodes 43a2.

S4 further includes S42. In S42, the pixel definition layer 44, the light-emitting film layer 45 and the cathode layer 46 are sequentially formed on a side of the anode layer 43 away from the base substrate 10. The pixel definition layer 44 includes a plurality of openings, and each opening exposes an anode 43a. The light-emitting film layer 45 includes a plurality of light-emitting layers 45a, and each light-emitting layer 45a is located within an opening and in contact with a respective anode 43a. The cathode layer 46 is formed on a side of both the light-emitting film layer 45 and the pixel definition layer 44 away from the base substrate 10. Each anode 43a, a respective light-emitting layer 45a and a portion of the cathode layer 46 that is located within a respective opening constitute a light-emitting device 41.

In S5, as shown in FIG. 18E, an encapsulation layer 50 is formed on a side of the light-emitting device layer 40 away from the base substrate 10. The encapsulation layer 50 encapsulates the light-emitting device layer 40. The encapsulation layer 50 is used for protecting the light-emitting device layer 40, so that the light-emitting device layer 40 may be prevented from being damaged by the outside, and corrosions of moisture and oxygen may be avoided.

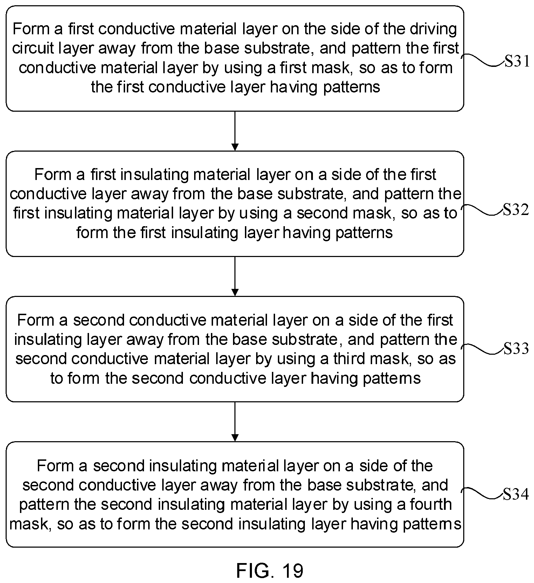

In some embodiments, as shown in FIGS. 5 and 18C, the connection layer 30 includes the first conductive layer 32, the first insulating layer 33, the second conductive layer 34 and the second insulating layer 35 that are sequentially arranged on the side of the driving circuit layer 20 away from the base substrate 10. As shown in FIG. 19, S3 in which the connection layer 30 is formed on the side of the driving circuit layer 20 away from the base substrate 10 includes S31 to S34.

In S31, a first conductive material layer 32a is formed on the side of the driving circuit layer 20 away from the base substrate 10, and the first conductive material layer 32a is patterned by using a first mask 32", so as to form the first conductive layer 32 having patterns.

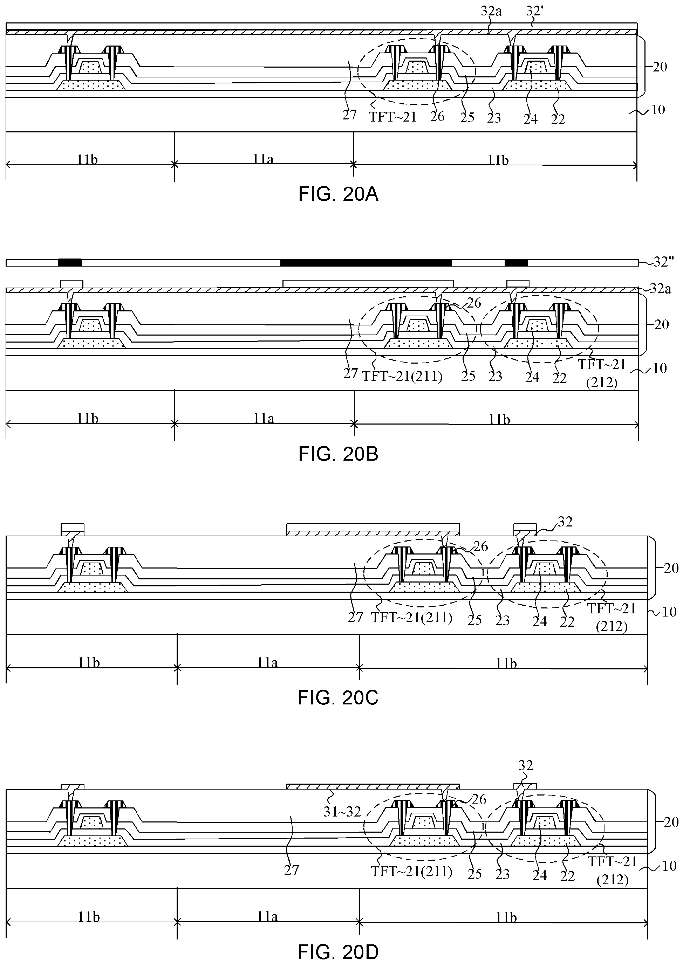

For example, as shown in FIGS. 20A to 20D, S31 includes S311 to S315.

In S311, as shown in FIG. 20A, the first conductive material layer 32a is formed on the side of the driving circuit layer 20 away from the base substrate 10. The first conductive material layer 32a is a film layer covering the entire display region 10a.

In S312, as shown in FIG. 20A, a first photoresist layer 32' is formed on a side of the first conductive material layer 32a away from the base substrate 10.

In S313, as shown in FIG. 20B, the first photoresist layer 32' is exposed by using the first mask 32", and the exposed first photoresist layer 32' is developed, so as to form respective patterns in the first photoresist layer 32'.

In S314, as shown in FIG. 20C, the first conductive material layer 32a and the first photoresist layer 32' are etched by using dry etching.

In S315, as shown in FIG. 20D, a portion of the first conductive layer 32 exposed by the first photoresist layer 32' is removed, portions of the first conductive material layer 32a that are remained constitute the first conductive layer 32, and the first conductive layer 32 has the patterns. For example, the patterns of the first conductive layer 32 include connection lines 31 such as first lines 311 and/or second lines 312.

In S32, a first insulating material layer is formed on a side of the first conductive layer 32 away from the base substrate 10, and the first insulating material layer is patterned by using a second mask, so as to form the first insulating layer 33 having patterns.

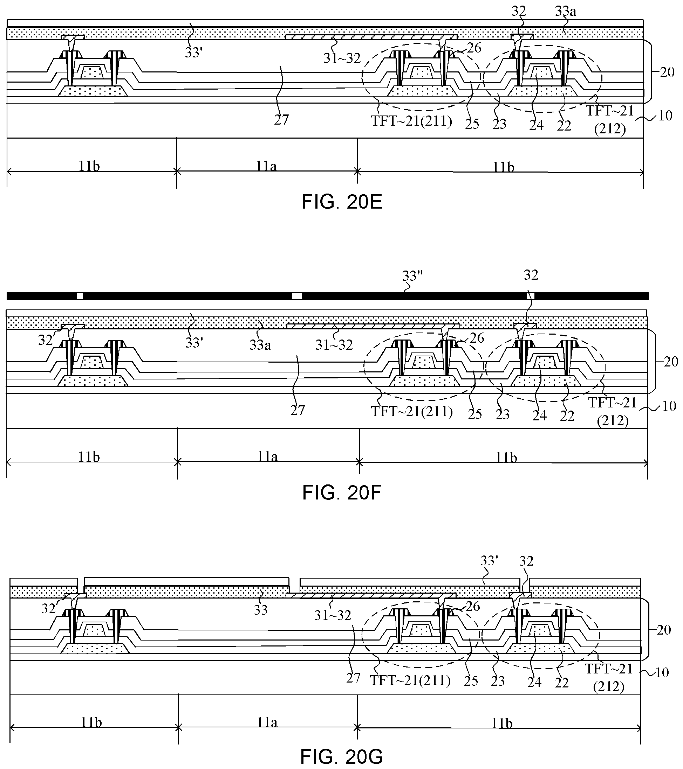

As shown in FIGS. 20E to 20H, for example, forming the first insulating layer 33 having the patterns on the first conductive layer 32 includes S321 to S325.

In S321, as shown in FIG. 20E, the first insulating material layer 33a is formed on the side of the first conductive layer 32 away from the base substrate 10. The first insulating material layer 33a is a film layer covering the entire display region 10a. The first insulating material layer 33a may be made of PI.

In S322, as shown in FIG. 20E, a second photoresist layer 33' is formed on a side of the first insulating material layer 33a away from the base substrate 10.

In S323, as shown in FIG. 20F, the second photoresist layer 33' is exposed by using the second mask 33", and the exposed second photoresist layer 33' is developed, so as to form respective patterns in the second photoresist layer 33'.

In S324, as shown in FIG. 20G, the first insulating material layer 33a and the second photoresist layer 33' are etched by using dry etching.

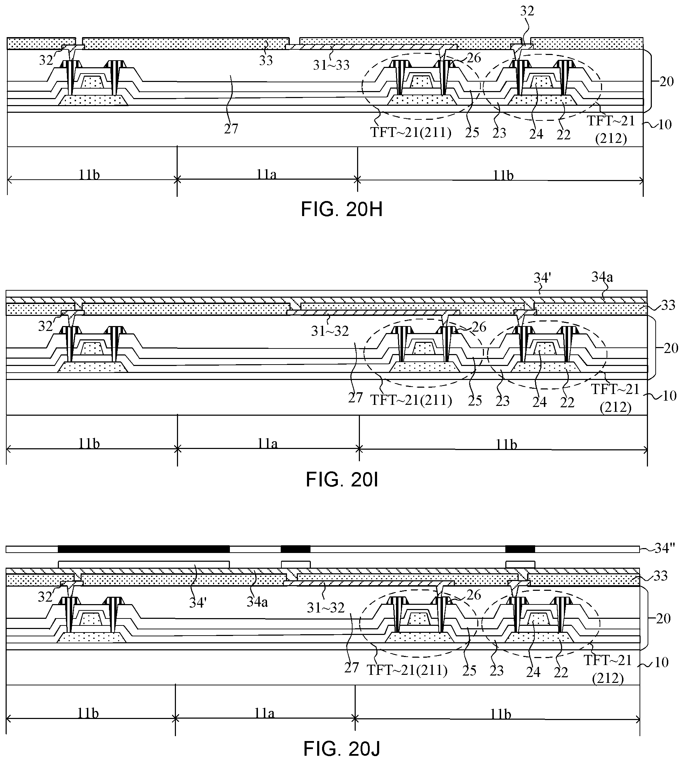

In S325, as shown in FIG. 20H, a portion of the first insulating layer 33 exposed by the second photoresist layer is removed, portions of the first insulating material layer 33a that are remained constitute the first insulating layer 33, and the first insulating layer 33 has the patterns. For example, the patterns of the first insulating layer 33 include first via holes 331.

In S33, a second conductive material layer is formed on a side of the first insulating layer away from the base substrate, and the second conductive material layer is patterned by using a third mask, so as to form the second conductive layer having patterns.

As shown in FIGS. 20I to 20L, for example, forming the second conductive layer 34 having the patterns on the side of the first insulating layer 33 away from the base substrate 10 includes S331 to S334.

In S331, as shown in FIG. 20I, the second conductive material layer 34a is formed on a side of the second conductive layer 32 away from the base substrate 10. The second conductive material layer 34a is a film layer covering the entire display region 10a.

In S332, as shown in FIG. 20I, a third photoresist layer 34' is formed on a side of the second conductive material layer 34a away from the base substrate 10.

In S333, as shown in FIG. 20J, the third photoresist layer 34' is exposed by using the third mask 34", and the exposed third photoresist layer 34' is developed, so as to form respective patterns in the third photoresist layer 34'.

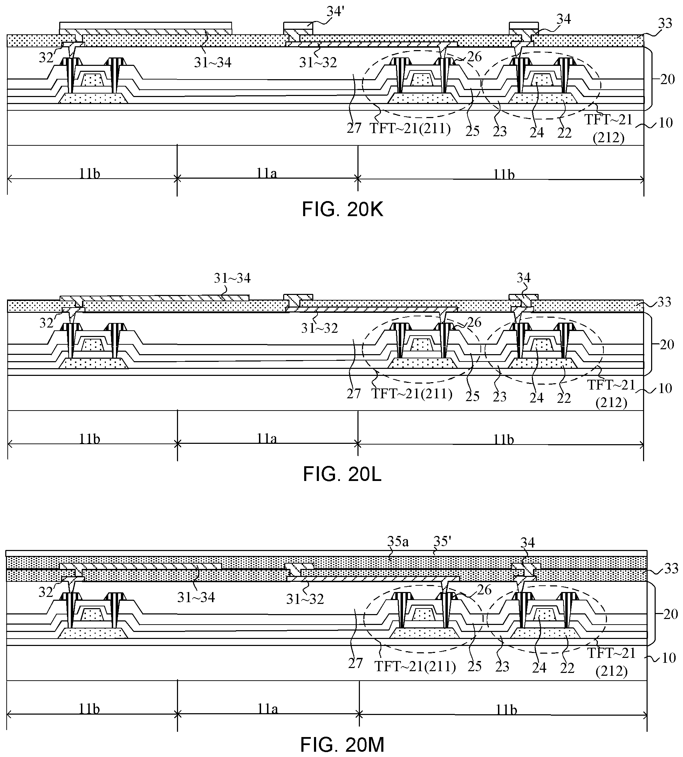

In S334, as shown in FIG. 20K, the second conductive material layer and the third photoresist layer 34' are etched by using dry etching.

In S335, as shown in FIG. 20L, a portion of the second conductive layer 34 exposed by the third photoresist layer is removed, portions of the second conductive material layer that are remained constitute the second conductive layer 34, and the second conductive layer 34 has the patterns. For example, the patterns of the second conductive layer 34 include first lines 311 and/or second lines 312.

In S34, a second insulating material layer is formed on a side of the second conductive layer away from the base substrate, and the second insulating material layer is patterned by using a fourth mask, so as to form the second insulating layer having patterns.

As shown in FIGS. 20M to 20P, for example, forming the second insulating layer 35 having the patterns on the side of the second conductive layer 34 away from the base substrate 10 includes S341 to S34.

In S341, as shown in FIG. 20M, the second insulating material layer 35a is formed on the side of the second conductive layer 34 away from the base substrate 10. The second insulating material layer 35a is a film layer covering the entire display region 10a. The second insulating material layer 35a may be made of PI.

In S342, as shown in FIG. 20M, a fourth photoresist layer 35' is formed on a side of the second insulating material layer 35a away from the base substrate 10.

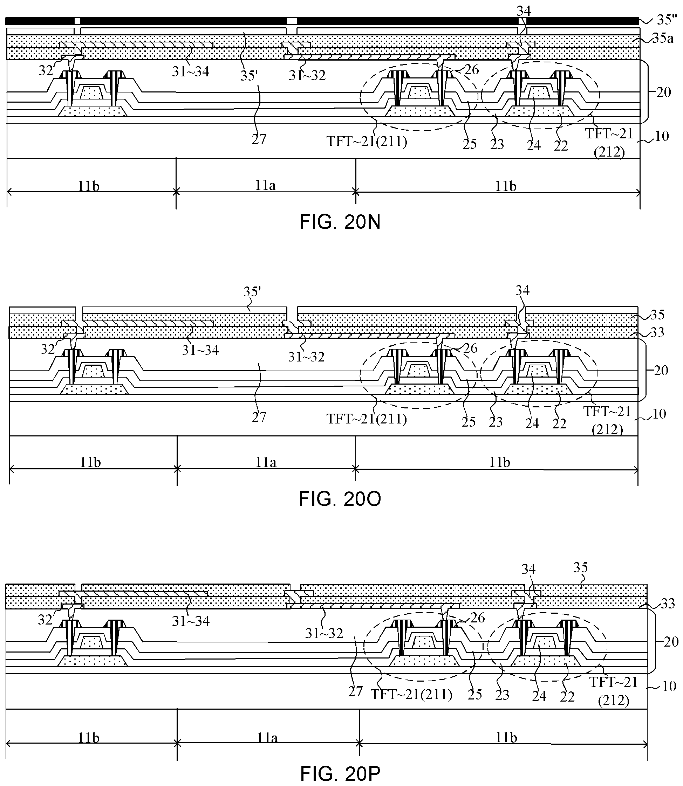

In S343, as shown in FIG. 20N, the fourth photoresist layer 35' is exposed by using the fourth mask 35", and the exposed fourth photoresist layer 35' is developed, so as to form respective patterns in the fourth photoresist layer 35'.

In S344, as shown in FIG. 20O, the second insulating material layer 35a and the fourth photoresist layer 35' are etched by using dry etching.

In S345, as shown in FIG. 20P, a portion of the second insulating layer 35 exposed by the fourth photoresist layer is removed, portions of the second insulating material layer that are remained constitute the second insulating layer 35, and the second insulating layer 35 has the patterns. For example, the patterns of the second insulating layer 35 include second via holes 351.

The method of manufacturing the display panel 100 provided in the present disclosure is used for manufacturing the display panel as shown in FIG. 5, since the connection layer includes only two conductive layers and two insulating layers, in the process of manufacturing the connection layer, four patterning operations are performed by respectively using four masks. In this way, the number of times of using the mask is reduced, the manufacturing process is simplified, and the efficiency may be improved, thereby improving the capacity. In addition, a thickness, through which light is transmitted, of the optical sensor in the second display region may be reduced, the efficiency of the light transmittance may be improved, the operation performance of the optical sensor may be improved, and the display quality of the display panel may be ensured.

The foregoing descriptions are merely specific implementations of the present disclosure, but the protection scope of the present disclosure is not limited thereto. Changes or replacements that any person skilled in the art could conceive of within the technical scope of the present disclosure shall be included in the protection scope of the present disclosure. Therefore, the protection scope of the present disclosure shall be subject to the protection scope of the claims.

## Claims

1. A display panel including a display region, the display region including a first display region and a second display region;
the display panel comprising:
a base substrate;
a driving circuit layer disposed on a side of the base substrate; the driving circuit layer including a plurality of first-type pixel driving circuits located in the first display region;
a connection layer including a plurality of connection lines; the plurality of connection lines including a plurality of first lines; and
an anode layer including a plurality of first-type anodes located in the second display region; wherein the plurality of first-type anodes include a plurality of first anodes, and at least two first anodes are electrically connected to a first-type pixel driving circuit via a first line.

2. The display panel according to claim 1, wherein the plurality of connection lines further include a plurality of third lines, a third line is connected to the at least two first anodes, the first line is connected to the third line and the first-type pixel driving circuit, so that the at least two first anodes are electrically connected to the first-type pixel driving circuit.

3. The display panel according to claim 1 or 2, wherein the plurality of first-type anodes further include a plurality of second anodes and a plurality of third anodes; the plurality of connection lines further include a plurality of second lines;
a second anode is electrically connected to another first-type pixel driving circuit via a second line, and a third anode is electrically connected to yet another first-type pixel driving circuit via another second line.

4. The display panel according to claim 3, wherein
the at least two first anodes constitute a first anode group; in a first anode group, a second anode and a third anode that are adjacent to one another, a length of a first line electrically connected to the first anode group is less than a length of a second line electrically connected to the second anode, and is less than a length of a second line electrically connected to the third anode.

5. The display panel according to claim 2, wherein
the connection layer is disposed on a side of the driving circuit layer away from the base substrate; and
the anode layer is disposed on a side of the connection layer away from the base substrate.

6. The display panel according to claim 5, wherein the connection layer includes at least one conductive layer and at least one insulating layer, and each conductive layer is provided with an insulating layer on a side away from the base substrate.

7. The display panel according to claim 6, wherein the connection layer includes:
a first conductive layer disposed on the side of the driving circuit layer away from the base substrate;
a first insulating layer disposed on a side of the first conductive layer away from the base substrate;
a second conductive layer disposed on a side of the first insulating layer away from the base substrate; and
a second insulating layer disposed on a side of the second conductive layer away from the base substrate;
wherein the first conductive layer includes first lines and/or second lines, and the second conductive layer includes first lines and/or second lines;
the plurality of connection lines further include the plurality of third lines, and the third line and the first line that are connected to each other are located in a same conductive layer;
the first insulating layer has first via holes therein, the second insulating layer has second via holes therein, the first conductive layer is electrically connected to the second conductive layer through the first via holes, and the second conductive layer is electrically connected to the anode layer through the second via holes.

8. The display panel according to any one of claims 1 to 7, wherein
the plurality of first-type anodes are arranged in a plurality of first-type anode rows, and at least one first-type anode row includes at least two first anodes, at least one second anode and at least one third anode that are arranged in a row;
at least two first anodes in a first-type anode row are electrically connected to a first line;
or
the plurality of first-type anodes are arranged in a plurality of first-type anode columns, and at least one first-type anode column includes at least two first anodes, at least one second anode and at least one third anode that are arranged in a column;
at least two first anodes in a first-type anode column are electrically connected to a first line.

9. The display panel according to claim 8, wherein
first-type anodes in each of the at least one first-type anode row are cyclically arranged according to an order of a second anode, a first anode, a third anode and a first anode;
the plurality of connection lines are arranged to constitute a plurality of line groups, and a line group includes at least one first line and at least two second lines; the plurality of connection lines each extend in a first direction, and the first direction is a row direction in which anodes are arranged; wherein
in the line group, a first line is connected to the at least two first anodes in the first-type anode row, and a second line is connected to a second anode or a third anode in the first-type anode row;
or
in the line group, a first line is connected to the at least two first anodes in the first-type anode row, the at least two second lines in the line group include at least one first sub-line and at least one second sub-line, a first sub-line is connected to the second anode or the third anode in the first-type anode row, and a second sub-line is connected to a second anode or a third anode in another first-type anode row adjacent to the first-type anode row.

10. The display panel according to claim 8, wherein
first-type anodes in each of the at least one first-type anode column are cyclically arranged according to an order of a second anode, a first anode, a third anode and a first anode;
the plurality of connection lines are arranged to constitute a plurality of line groups, and a line group includes at least one first line and at least two second lines; the plurality of connection lines each extend in a second direction, and the second direction is a column direction in which anodes are arranged; wherein
in the line group, a first line is connected to the at least two first anodes in the first-type anode column, and a second line is connected to a second anode or a third anode in the first-type anode column;
or
in the line group, a first line is connected to the at least two first anodes in the first-type anode column, the at least two second lines in the line group include at least one first sub-line and at least one second sub-line, a first sub-line is connected to the second anode or the third anode in the first-type anode column, and a second sub-line is connected to a second anode or a third anode in another first-type anode column.

11. The display panel according to claim 9 or 10, wherein
orthographic projections of the plurality of first-type pixel driving circuits on the base substrate are located on one or two sides, in an extending direction of the plurality of connection lines, of orthographic projections of the plurality of first-type anodes on the base substrate.

12. The display panel according to claim 11, wherein
a second conductive layer further includes a plurality of second connection portions, a second connection portion is electrically connected to a first-type anode, and a connection line located in the second conductive layer is electrically connected to the first-type anode via the second connection portion; and
a first conductive layer further includes a plurality of first connection portions, a first connection portion is electrically connected to the second connection portion, and a connection line located in the first conductive layer is electrically connected to the first-type anode via the first connection portion and the second connection portion that are connected to each other.

13. The display panel according to claim 12, wherein
the plurality of first lines and a plurality of third lines are located in the second conductive layer; in a first line and a third line that are connected to each other, the third line is connected to two adjacent second connection portions, so as to be connected to two adjacent first anodes; the first line is connected to one of the two adjacent second connection portions; an orthographic projection, on the base substrate, of the one of the two adjacent second connection portions that is connected to the first line is closer to an orthographic projection, on the base substrate, of a first-type pixel driving circuit electrically connected to the two adjacent first anodes than an orthographic projection, on the base substrate, of another of the two adjacent second connection portions;
or
the plurality of first lines and a plurality of third lines are located in the first conductive layer; in a first line and a third line that are connected to each other, the third line is connected to two adjacent first connection portions, so as to be connected to two adjacent first anodes; the first line is connected to one of the two adjacent first connection portions; an orthographic projection, on the base substrate, of the one of the two adjacent first connection portions that is connected to the first line is closer to an orthographic projection, on the base substrate, of a first-type pixel driving circuit electrically connected to the two adjacent first anodes than an orthographic projection, on the base substrate, of another of the two adjacent first connection portions.

14. The display panel according to claim 13, wherein
the driving circuit layer further includes a plurality of second-type pixel driving circuits arranged in an array in the first display region, and the plurality of first-type pixel driving circuits are respectively disposed in gaps of the array of the plurality of second-type pixel driving circuits; and
the anode layer further includes a plurality of second-type anodes located in the first display region, and a second-type anode is electrically connected to a second-type pixel driving circuit.

15. A display apparatus, comprising:
the display panel according to any one of claims 1 to 14; and
at least one sensor; the sensor being disposed on a non-display side of the display panel, and an orthographic projection of the sensor on the display panel is located in the second display region.

16. A method of manufacturing a display panel, wherein the display panel includes a display region, and the display region includes a first display region and a second display region;
the method of manufacturing the display panel comprises:
providing a base substrate;
forming a driving circuit layer on the base substrate; wherein the driving circuit layer includes a plurality of first-type pixel driving circuits, and the plurality of first-type pixel driving circuits are disposed in the first display region;
forming a connection layer; wherein the connection layer includes a plurality of connection lines, and the plurality of connection lines include first lines; and
forming an anode layer; wherein the anode layer includes a plurality of first-type anodes located in the second display region; the plurality of first-type anodes include a plurality of first anodes, a plurality of second anodes and a plurality of third anodes, at least two first anodes are electrically connected to a first-type pixel driving circuit via a first line, a second anode is electrically connected to another first-type pixel driving circuit via a second line, and a third anode is electrically connected to yet another first-type pixel driving circuit via another second line.

17. The method of manufacturing the display panel according to claim 16, wherein the connection layer includes a first conductive layer, a first insulating layer, a second conductive layer and a second insulating layer that are sequentially arranged on a side of the driving circuit layer away from the base substrate;
forming the connection layer on the side of the driving circuit layer away from the base substrate includes:
forming a first conductive material layer on the side of the driving circuit layer away from the base substrate, and patterning the first conductive material layer by using a first mask, so as to form the first conductive layer having patterns;
forming a first insulating material layer on a side of the first conductive layer away from the base substrate, and patterning the first insulating material layer by using a second mask, so as to form the first insulating layer having patterns;
forming a second conductive material layer on a side of the first insulating layer away from the base substrate, and patterning the second conductive material layer by using a third mask, so as to form the second conductive layer having patterns; and
forming a second insulating material layer on a side of the second conductive layer away from the base substrate, and patterning the second insulating material layer by using a fourth mask, so as to form the second insulating layer having patterns;
wherein patterns of the first conductive layer include first lines and/or second lines; patterns of the second conductive layer include first lines and/or second lines; patterns of the first insulating layer include first via holes; patterns of the second insulating layer include second via holes.
